# EUROPEAN PATENT APPLICATION

(11) **EP 4 672 943 A1**
(43) Date of publication of application: **31.12.2025**
(21) Application number: 25183278.8
(22) Date of filing: 17.06.2025
(51) Int. Cl.: H10K 59/38, H10K 59/80

(54) **DISPLAY DEVICE AND ELECTRONIC DEVICE INCLUDING THE DISPLAY DEVICE**

(30) Priority: 26.06.2024 KR 20240083760; 26.07.2024 KR 20240099613
(71) Applicant: Samsung Display Co., Ltd., Yongin-si, Gyeonggi-do 17113 (KR)
(72) Inventor: SEO, Bong Sung, Yongin-si (KR); SON, Jong Ho, Yongin-si (KR)
(74) Representative: Marks & Clerk LLP

(57) **Abstract**

A display device is provided. The display device includes a semiconductor substrate, a plurality of light emitting elements on the semiconductor substrate, and a plurality of patterns on the plurality of light emitting elements and overlapping the plurality of light emitting elements, wherein the plurality of light emitting elements includes a first light emitting element at a center of the display device and a second light emitting element on one side of the first light emitting element, the plurality of patterns includes a first pattern overlapping the first light emitting element and a second pattern overlapping the second light emitting element, the first pattern includes a first structure and a second structure, the second pattern includes a third structure and a fourth structure, a width of the first structure and a width of the second structure are the same, and a width of the third structure and a width of the fourth structure are different.

## Description

### BACKGROUND

### 1. Field

The present disclosure relates to a display device and an electronic device including the display device.

### 2. Description of the Related Art

As the information society develops, demands for display devices for displaying images are increasing in various forms. The display devices may be liquid crystal displays, field emission displays, and light emitting displays. The light emitting displays include an organic light emitting display including an organic light emitting diode (OLED) element as a light emitting element and an inorganic light emitting display including an inorganic light emitting diode element as a light emitting element.

Among the display devices, a head mounted display (HMD) is an image display device that is worn on a user's head in the form of glasses or a helmet and forms a focus at a distance close to user's eyes in front of the user's eyes. The head mounted display may implement virtual reality (VR) or augmented reality (AR).

The head mounted display magnifies and displays an image displayed by a small display device using a plurality of lenses. Therefore, a display device applied to the head mounted display needs to provide a high-resolution image, for example, an image having a resolution of 3000 pixels per inch (PPI) or more. To this end, an organic light emitting diode on silicon (OLEDoS), which is a small organic light emitting display device having a high resolution, has been used as the display device applied to the head mounted display. The OLEDoS is a device that displays an image by disposing organic light emitting diodes (OLEDs) on a semiconductor wafer substrate including complementary metal oxide semiconductors (CMOSs).

### SUMMARY

Aspects and features of embodiments of the present disclosure provide a display device in which a path of light is adjusted according to chief ray angle (CRA) to increase field of view (FOV).

Aspects and features of embodiments of the present disclosure also provide a display device with more simplified process.

However, aspects and features of embodiments of the present disclosure are not limited to those set forth herein. The above and other aspects and features of embodiments of the present disclosure will become more apparent to one of ordinary skill in the art to which the present disclosure pertains by referencing the detailed description of the present disclosure given below.

According to one or more embodiments of the present disclosure, there is provided a display device including, a semiconductor substrate, a plurality of light emitting elements on the semiconductor substrate, and a plurality of patterns on the plurality of light emitting elements and overlapping the plurality of light emitting elements, wherein the plurality of light emitting elements includes a first light emitting element at a center of the display device and a second light emitting element on one side of the first light emitting element, the plurality of patterns includes a first pattern overlapping the first light emitting element and a second pattern overlapping the second light emitting element, the first pattern includes a first structure and a second structure, the second pattern includes a third structure and a fourth structure,a width of the first structure and a width of the second structure are the same, and a width of the third structure and a width of the fourth structure are different.

In one or more embodiments, the third structure may be closer to the center than the fourth structure is, and a width of the third structure may be smaller than a width of the fourth structure.

In one or more embodiments, the second pattern may further include a fifth structure and a sixth structure, the third structure, the fourth structure, the fifth structure, and the sixth structure may be arranged away from the center in that sequential order, and the widths of the third structure, the fourth structure, the fifth structure, and the sixth structure may increase in sequential order.

In one or more embodiments, the width of the third structure may be 94 nm to 134 nm, the width of the fourth structure may be 104 nm to 144 nm, the width of the fifth structure may be 114 nm to 154 nm, and the width of the sixth structure may be 150 nm to 190 nm.

In one or more embodiments, a proceeding direction of light that passed through the second pattern may be tilted from a thickness direction of the semiconductor substrate by 25 to 35 degrees.

In one or more embodiments, the plurality of light emitting elements may include a third light emitting element between the first light emitting element and the second light emitting element, the plurality of patterns may include a third pattern overlapping the third light emitting element, the third pattern may include a seventh structure and an eighth structure, and a width of the seventh structure and a width of the eighth structure may be different.

In one or more embodiments, the seventh structure may be closer to the center than the eighth structure is, and the width of the seventh structure may be smaller than the width of the eighth structure.

In one or more embodiments, the width of the third structure may be smaller than the width of the seventh structure, and the width of the fourth structure may be smaller than the eighth structure.

In one or more embodiments, a distance between the third structure and the fourth structure may be greater than the distance between the seventh structure and the eighth structure.

In one or more embodiments, the plurality of light emitting elements may include a fourth light emitting element on an other side of the first light emitting element, the plurality of patterns may include a fourth pattern overlapping the fourth light emitting element, the fourth pattern may include a ninth structure and a tenth structure, and a width of the ninth structure may be the same as a width of the third structure, and a width of the tenth structure may be the same as a width of the fourth structure.

In one or more embodiments, the second pattern and the fourth pattern may be symmetrical to each other in left and right directions with respect to the first pattern.

In one or more embodiments, each of the plurality of light emitting elements and the plurality of patterns may be on one straight line.

In one or more embodiments, the first to fourth structures may include silicon or a metal.

In one or more embodiments, the first to fourth structures may have nano-pin, nano-rod, or nano-polygon shapes.

According to one or more embodiments of the present disclosure, there is provided a display device including, a semiconductor substrate, a plurality of light emitting elements on the semiconductor substrate, and a pattern layer including a plurality of patterns overlapping the plurality of light emitting elements and located on the plurality of light emitting elements, wherein the plurality of light emitting elements includes a first light emitting element at a center of the display device and a second light emitting element on one side of the first light emitting element, the pattern layer does not include the pattern in the overlapping area with the first light emitting element and includes a first pattern overlapping the second light emitting element, the first pattern includes a first structure and a second structure, and a width of the first structure and a width of the second structure are different.

In one or more embodiments, the first structure may be closer to the center than the second structure is, and the width of the first structure may be smaller than the width of the second structure.

In one or more embodiments, the first pattern may further include a third structure and a fourth structure, the first structure, the second structure, the third structure, and the fourth structure may be arranged away from the center in that sequential order, and the widths of the first structure, the second structure, the third structure, and the fourth structure may increase in sequential order.

In one or more embodiments, the plurality of light emitting elements may include a third light emitting element between the first light emitting element and the second light emitting element, the plurality of patterns may include a second pattern overlapping the third light emitting element, the second pattern may include a fifth structure and a sixth structure, and a width of the fifth structure and a width of the sixth structure may be different.

In one or more embodiments, the plurality of light emitting elements may include a fourth light emitting element on an other side of the first light emitting element, the plurality of patterns may include a third pattern overlapping the fourth light emitting element, the third pattern may include a seventh structure and an eighth structure, and a width of the seventh structure may be the same as the width of the first structure and a width of the eighth structure may be the same as the width of the second structure.

In one or more embodiments, each of the plurality of light emitting elements and the plurality of patterns may be on one straight line.

In one or more embodiments, an electronic device includes: a display device; and a display device driver configured to drive the display device, the display device including: a semiconductor substrate; a plurality of light emitting elements on the semiconductor substrate; and a plurality of patterns on the plurality of light emitting elements and overlapping the plurality of light emitting elements, wherein: the plurality of light emitting elements includes a first light emitting element at a center of the display device and a second light emitting element on one side of the first light emitting element; the plurality of patterns includes a first pattern overlapping the first light emitting element and a second pattern overlapping the second light emitting element; the first pattern includes a first structure and a second structure; the second pattern includes a third structure and a fourth structure; and a width of the first structure and a width of the second structure are the same.

In one or more embodiments, the electronic device may include a mobile phone, a smartphone, a tablet personal computer, a mobile communication terminal, an electronic organizer, an electronic book, a portable multimedia player (PMP), a navigation system, an ultra-mobile PC (UMPC), televisions, laptops, monitors, billboards, a head mounted display (HMD), and an internet of things (IOT) terminal.

At least some of the above and other features of the invention are set out in the claims.

In accordance with a display device according to one or more embodiments, a path of light may be adjusted according to chief ray angle (CRA) to increase field of view (FOV).

In accordance with a display device according to one or more embodiments, a process may be simplified.

However, effects, aspects, and features of embodiments of the present disclosure are not limited to those exemplified above and various other effects, aspects, and features are incorporated herein.

### BRIEF DESCRIPTION OF THE DRAWINGS

The above and other aspects and features of the present disclosure will become more apparent by describing in detail example embodiments thereof with reference to the attached drawings, in which:
FIG. 1 is an exploded perspective view showing a display device according to one or more embodiments;
FIG. 2 is a block diagram illustrating a display device according to one or more embodiments;
FIG. 3 is an equivalent circuit diagram of a first sub-pixel according to one or more embodiments;
FIG. 4 is a plan view illustrating an example of a display panel according to one or more embodiments;
FIGS. 5 and 6 are plan views illustrating embodiments of the display area of FIG. 4;
FIG. 7 is a cross-sectional view illustrating an example of a display panel taken along the line X1-X1' of FIG. 5;
FIG. 8 is a cross-sectional view illustrating another example of a display panel taken along the line X1-X1' of FIG. 5;
FIG. 9 is a cross-sectional view illustrating still another example of a display panel taken along the line X1-X1' of FIG. 5;
FIG. 10 is a schematic cross-sectional view illustrating a display element layer, a color filter layer, lenses, a nano pattern layer, and an optical module of a display device according to one or more embodiments;
FIG. 11 is a schematic cross-sectional view illustrating a display panel and an optical module according to one or more embodiments;
FIG. 12 is a view illustrating an example of an image displayed by a display device according to a comparative embodiment;
FIG. 13 is a view illustrating an example of an image displayed by a display device according to one or more embodiments;
FIG. 14 is a cross-sectional view illustrating nano patterns overlapping the first pixel illustrated in FIG. 10;
FIG. 15 is a cross-sectional view illustrating nano patterns overlapping the third pixel illustrated in FIG. 10;
FIG. 16 is a perspective view illustrating a second nano pattern from among a nano pattern layer according to one or more embodiments;
FIG. 17 is a perspective view illustrating a sixth nano pattern from among a nano pattern layer according to one or more embodiments;
FIG. 18 is a plan view illustrating first to third nano patterns from among a nano pattern layer according to one or more embodiments;
FIG. 19 is a plan view illustrating fourth to sixth nano patterns among a nano pattern layer according to one or more embodiments;
FIG. 20 is a cross-sectional view illustrating nano patterns overlapping a first pixel of a display device according to another embodiment;
FIG. 21 is a perspective view illustrating a nano pattern layer according to still another embodiment;
FIG. 22 is a perspective view illustrating a nano pattern layer according to still another embodiment;
FIG. 23 is an exploded perspective view illustrating a head mounted display device according to one or more embodiments;
FIG. 24 is a perspective view illustrating an augmented reality content providing device according to one or more embodiments;
FIG. 25 is a rear exploded perspective view of the augmented reality content providing device of FIG. 24; and
FIG. 26 is a front exploded perspective view of the augmented reality content providing device of FIG. 24.

### DETAILED DESCRIPTION

Embodiments of the present disclosure will now be described more fully hereinafter with reference to the accompanying drawings, in which embodiments of the present disclosure are shown. The present disclosure may, however, be embodied in different forms and should not be construed as limited to the embodiments set forth herein. Rather, these embodiments are provided so that the present disclosure will be thorough and complete, and will fully convey the scope of the present disclosure to those skilled in the art.

It will also be understood that when a layer is referred to as being "on" another layer or substrate, it can be directly on the other layer or substrate, or intervening layers may also be present. The same reference numbers indicate the same components throughout the specification.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Hereinafter, embodiments of the present disclosure will be described in detail with reference to the accompanying drawings.

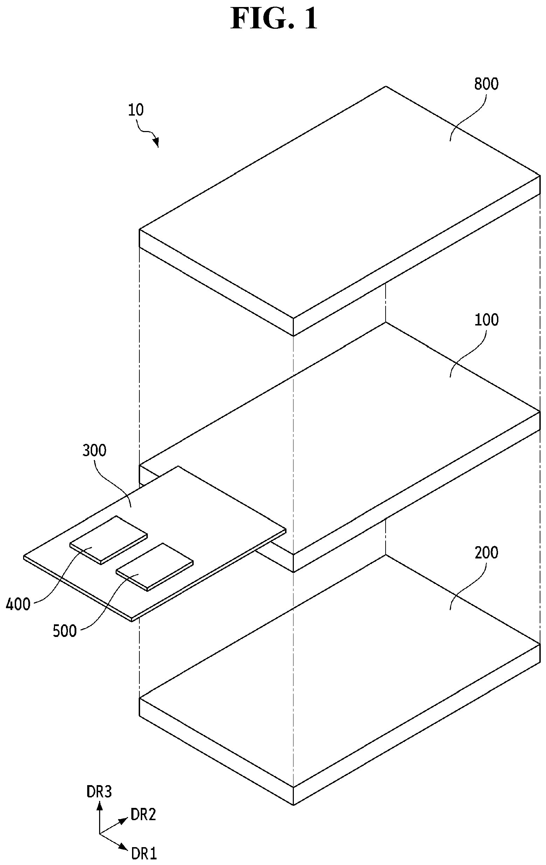

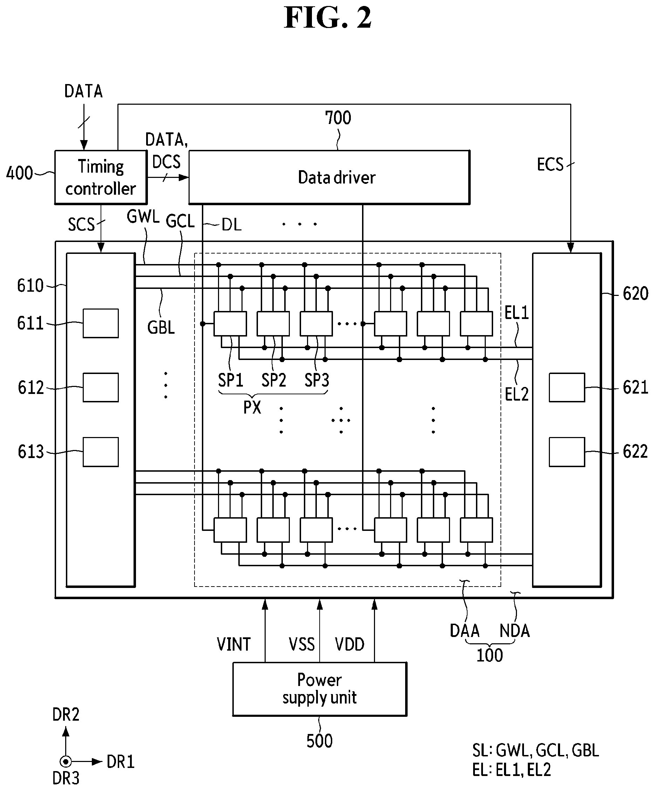

FIG. 1 is an exploded perspective view showing a display device according to one or more embodiments. FIG. 2 is a block diagram illustrating a display device according to one or more embodiments.

Referring to FIGS. 1 and 2, a display device 10 according to one or more embodiments may be a device for displaying a moving image and/or a still image. The display device 10 according to one or more embodiments may be applied to portable electronic devices such as a mobile phone, a smartphone, a tablet personal computer, a mobile communication terminal, an electronic organizer, an electronic book, a portable multimedia player (PMP), a navigation system, an ultra-mobile PC (UMPC), and/or the like. For example, the display device 10 according to one or more embodiments may be applied as a display unit of a television, a laptop, a monitor, a billboard, and/or an Internet-of-Things (IoT) terminal. Alternatively, the display device 10 according to one or more embodiments may be applied to a smart watch, a watch phone, a head mounted display (HMD) for implementing virtual reality and augmented reality, and/or the like.

The display device 10 according to one or more embodiments may include a display panel 100, a heat dissipation layer 200, a circuit board 300, a timing control circuit (e.g., a timing controller) 400, a power supply circuit (e.g., a power supply unit) 500, and an optical module 800.

The display panel 100 may have a planar shape similar to a quadrilateral shape. For example, the display panel 100 may have a planar shape similar to a quadrilateral shape, having a short side of a first direction DR1 and a long side of a second direction DR2 intersecting the first direction DR1. In the display panel 100, a corner where a short side in the first direction DR1 and a long side in the second direction DR2 meet may be right-angled or rounded with a suitable curvature (e.g., a predetermined curvature). The planar shape of the display panel 100 is not limited to a quadrilateral shape, and may be a shape similar to another polygonal shape, a circular shape, or an elliptical shape. The planar shape of the display device 10 may conform to the planar shape of the display panel 100, but the present disclosure is not limited thereto.

In the illustrated figure, the first direction DR1 and the second direction DR2 cross each other as horizontal directions. For example, the first direction DR1 and the second direction DR2 may be orthogonal to each other. In addition, a third direction DR3 crosses the first direction DR1 and the second direction DR2, and they may be, for example, perpendicular directions orthogonal to each other. Unless otherwise defined, in the present specification, directions indicated by arrows of the first to third directions DR1, DR2, and DR3 may be referred to as one side, and the opposite directions thereto may be referred to as the other side. Also, the terms "above," "upper side," "upper portion," "top," and "top surface," as used herein, refer to a direction indicated by an arrow in the drawing in the third direction DR3 based on the drawings, and the terms "below," "lower side," "lower portion," "bottom," and "bottom surface," as used herein, refer to a direction opposite to the direction indicated by the arrow in the third direction DR3 based on the drawings.

The display panel 100 may include a display area DAA displaying an image and a non-display area NDA not displaying an image as shown in FIG. 2.

The display area DAA may include a plurality of pixels PX, a plurality of scan lines SL, a plurality of emission control lines EL, and a plurality of data lines DL.

The plurality of pixels PX may be arranged in a matrix form along the first direction DR1 and the second direction DR2. For example, the plurality of pixels PX may be arranged along rows and columns of a matrix along the first direction DR1 and the second direction DR2. The plurality of scan lines SL and the plurality of emission control lines EL may extend in the first direction DR1, while being disposed along the second direction DR2. The plurality of data lines DL may extend in the second direction DR2, while being disposed along the first direction DR1.

The plurality of scan lines SL may include a plurality of write scan lines GWL, a plurality of control scan lines GCL, and a plurality of bias scan lines GBL. The plurality of emission control lines EL may include a plurality of first emission control lines EL1 and a plurality of second emission control lines EL2.

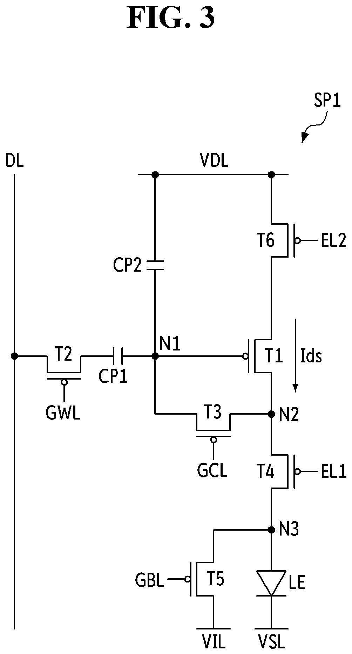

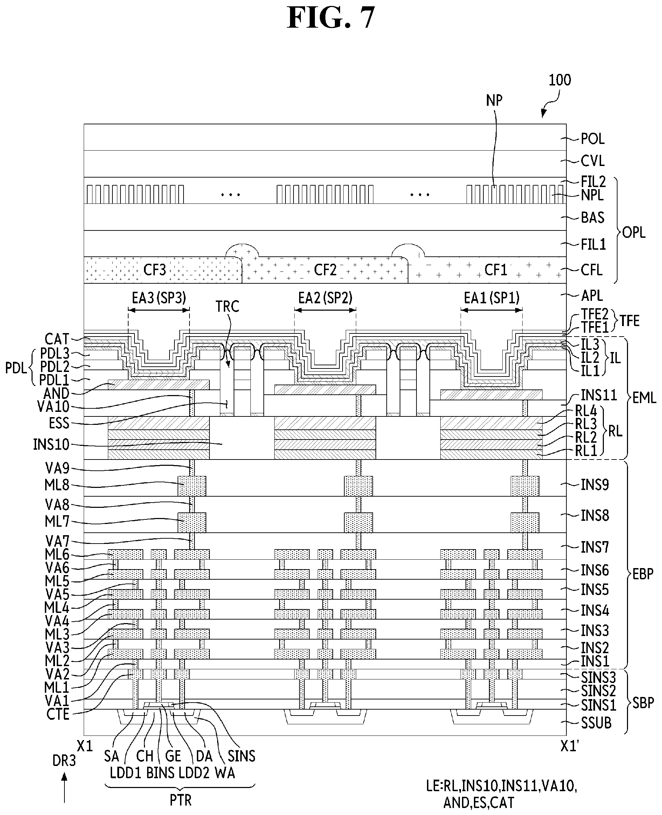

The plurality of pixels PX may include a plurality of sub-pixels SP1, SP2, and SP3. The plurality of sub-pixels SP1, SP2, and SP3 may include a plurality of pixel transistors as shown in FIG. 3 to be described later, and the plurality of pixel transistors may be formed by a semiconductor process and disposed on a semiconductor substrate SSUB (See FIG. 7). For example, the plurality of pixel transistors of a data driver 700 may be formed of complementary metal oxide semiconductor (CMOS).

Each of the plurality of sub-pixels SP1, SP2, and SP3 may be connected to one write scan line GWL from among the plurality of write scan lines GWL, one control scan line GCL from among the plurality of control scan lines GCL, one bias scan line GBL from among the plurality of bias scan lines GBL, one first emission control line EL1 from among the plurality of first emission control lines EL1, one second emission control line EL2 from among the plurality of second emission control lines EL2, and one data line DL from among the plurality of data lines DL. Each of the plurality of sub-pixels SP1, SP2, and SP3 may receive a data voltage of the data line DL in response to a write scan signal of the write scan line GWL, and emit light from the light emitting element according to the data voltage.

The non-display area NDA may include a scan driver 610, an emission driver 620, and the data driver 700.

The scan driver 610 may include a plurality of scan transistors, and the emission driver 620 includes a plurality of light emitting transistors. The plurality of scan transistors and the plurality of light emitting transistors may be formed through a semiconductor process, and disposed on the semiconductor substrate SSUB (see FIG. 7). For example, the plurality of scan transistors and the plurality of light emitting transistors may be formed of CMOS. Although it is illustrated in FIG. 2 that the scan driver 610 is disposed on the left side of the display area DAA and the emission driver 620 is disposed on the right side of the display area DAA, the present disclosure is not limited thereto. For example, the scan driver 610 and the emission driver 620 may be disposed on both the left side and the right side of the display area DAA.

The scan driver 610 may include a write scan signal output unit 611, a control scan signal output unit 612, and a bias scan signal output unit 613. Each of the write scan signal output unit 611, the control scan signal output unit 612, and the bias scan signal output unit 613 may receive a scan timing control signal SCS from the timing control circuit 400. The write scan signal output unit 611 may generate write scan signals according to the scan timing control signal SCS of the timing control circuit 400 and output them sequentially to the write scan lines GWL. The control scan signal output unit 612 may generate control scan signals in response to the scan timing control signal SCS and sequentially output them to the control scan lines GCL. The bias scan signal output unit 613 may generate bias scan signals according to the scan timing control signal SCS and output them sequentially to bias scan lines GBL.

The emission driver 620 may include a first emission control driver 621 and a second emission control driver 622. Each of the first emission control driver 621 and the second emission control driver 622 may receive the emission timing control signal ECS from the timing control circuit 400. The first emission control driver 621 may generate first emission control signals according to the emission timing control signal ECS and sequentially output them to the first emission control lines EL1. The second emission control driver 622 may generate second emission control signals according to the emission timing control signal ECS and sequentially output them to the second emission control lines EL2.

The data driver 700 may include a plurality of data transistors, and the plurality of data transistors may be formed through a semiconductor process, and disposed on the semiconductor substrate SSUB (see FIG. 7). For example, the plurality of data transistors may be formed of CMOS.

The data driver 700 may receive digital video data DATA and a data timing control signal DCS from the timing control circuit 400. The data driver 700 may convert the digital video data DATA into analog data voltages according to the data timing control signal DCS and output the analog data voltages to the data lines DL. In this case, the sub-pixels SP1, SP2, and SP3 are selected by the write scan signal of the scan driver 610, and data voltages may be supplied to the selected sub-pixels SP1, SP2, and SP3.

The heat dissipation layer 200 may overlap the display panel 100 in the third direction DR3, which is the thickness direction of the display panel 100. The heat dissipation layer 200 may be disposed on one surface of the display panel 100, for example, on the rear surface thereof. The heat dissipation layer 200 may serve to dissipate heat generated from the display panel 100. The heat dissipation layer 200 may include a metal layer having high thermal conductivity, such as graphite, silver (Ag), copper (Cu), and/or aluminium (Al).

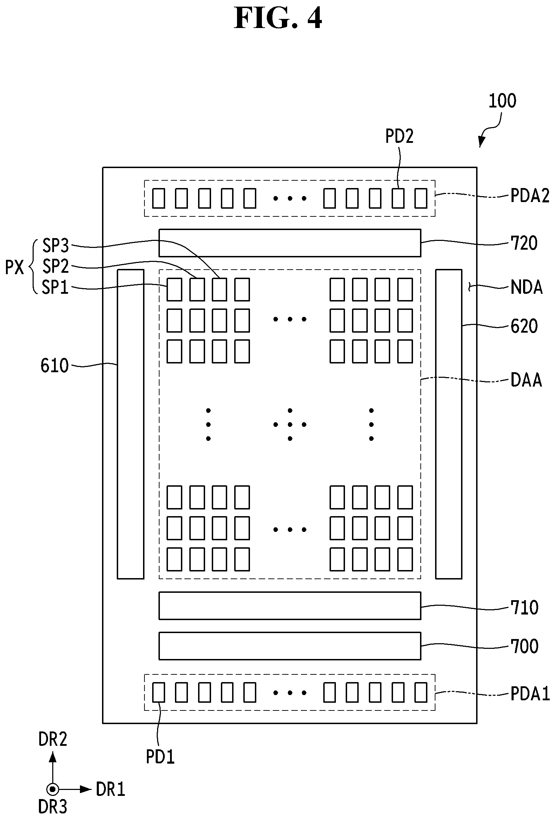

The circuit board 300 may be electrically connected to a plurality of first pads PD1 (see FIG. 4) of a first pad portion PDA1 (see FIG. 4) of the display panel 100 by using a conductive adhesive member such as an anisotropic conductive film. The circuit board 300 may be a flexible printed circuit board (FPCB) with a flexible material, and/or a flexible film. Although the circuit board 300 is illustrated in FIG. 1 as being unfolded, the circuit board 300 may be bent. In this case, one end of the circuit board 300 may be disposed on the rear surface of the display panel 100 and/or the rear surface of the heat dissipation layer 200. One end of the circuit board 300 may be an opposite end of the other end of the circuit board 300 connected to the plurality of first pads PD1 (see FIG. 4) of the first pad portion PDA1 (see FIG. 4) of the display panel 100 by using a conductive adhesive member.

The timing control circuit 400 may receive digital video data DATA and timing signals inputted from the outside. The timing control circuit 400 may generate the scan timing control signal SCS, the emission timing control signal ECS, and the data timing control signal DCS for controlling the display panel 100 in response to the timing signals. The timing control circuit 400 may output the scan timing control signal SCS to the scan driver 610, and output the emission timing control signal ECS to the emission driver 620. The timing control circuit 400 may output the digital video data DATA and the data timing control signal DCS to the data driver 700.

The power supply circuit 500 may generate a plurality of panel driving voltages according to a power voltage from the outside. For example, the power supply circuit 500 may generate a first driving voltage VSS, a second driving voltage VDD, and a third driving voltage VINT and supply them to the display panel 100. The first driving voltage VSS, the second driving voltage VDD, and the third driving voltage VINT will be described later in conjunction with FIG. 3.

Each of the timing control circuit 400 and the power supply circuit 500 may be formed as an integrated circuit (IC) and attached to one surface of the circuit board 300. In this case, the scan timing control signal SCS, the emission timing control signal ECS, digital video data DATA, and the data timing control signal DCS of the timing control circuit 400 may be supplied to the display panel 100 through the circuit board 300. Further, the first driving voltage VSS, the second driving voltage VDD, and the third driving voltage VINT of the power supply circuit 500 may be supplied to the display panel 100 through the circuit board 300.

Alternatively, each of the timing control circuit 400 and the power supply circuit 500 may be disposed in the non-display area NDA of the display panel 100, similarly to the scan driver 610, the emission driver 620, and the data driver 700. In this case, the timing control circuit 400 may include a plurality of timing transistors, and each power supply circuit 500 may include a plurality of power transistors. The plurality of timing transistors and the plurality of power transistors may be formed through a semiconductor process, and disposed on the semiconductor substrate SSUB (see FIG. 7). For example, the plurality of timing transistors and the plurality of power transistors may be formed of CMOS. Each of the timing control circuit 400 and the power supply circuit 500 may be disposed between the data driver 700 and the first pad portion PDA1 (see FIG. 4).

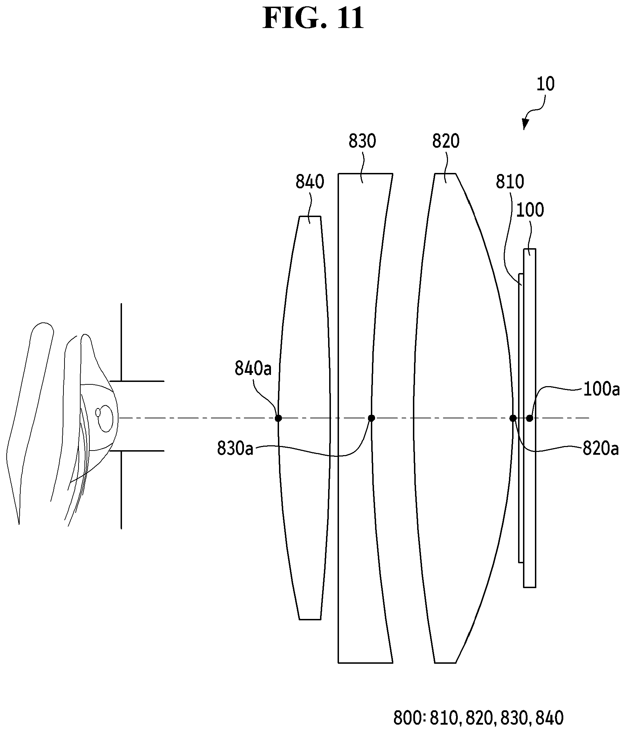

The optical module 800 may be disposed on the display panel 100. The optical module 800 may adjust the path and polarization state of light emitted from the display panel 100. The optical module 800 may implement folded optics that folds an optical path. The optical module 800 will be described later with reference to FIG. 11 and/or the like.

FIG. 3 is an equivalent circuit diagram of a first sub-pixel according to one or more embodiments.

Referring to FIG. 3 in addition to FIGS. 1 and 2, the first sub-pixel SP1 may be connected to the write scan line GWL, the control scan line GCL, the bias scan line GBL, the first emission control line EL1, the second emission control line EL2, and the data line DL. Further, the first sub-pixel SP1 may be connected to a first driving voltage line VSL to which the first driving voltage VSS corresponding to a low potential voltage is applied, a second driving voltage line VDL to which the second driving voltage VDD corresponding to a high potential voltage is applied, and a third driving voltage line VIL to which the third driving voltage VINT corresponding to an initialization voltage is applied. That is, the first driving voltage line VSL may be a low potential voltage line, the second driving voltage line VDL may be a high potential voltage line, and the third driving voltage line VIL may be an initialization voltage line. In this case, the first driving voltage VSS may be lower than the third driving voltage VINT. The second driving voltage VDD may be higher than the third driving voltage VINT.

The first sub-pixel SP1 may include a plurality of transistors T1 to T6, a light emitting element LE, a first capacitor CP1, and a second capacitor CP2.

The light emitting element LE may emit light in response to a driving current (source-drain current) I_{ds} flowing through the channel of a first transistor T1. A light emission amount of the light emitting element LE may be proportional to the driving current. The light emitting element LE may be disposed between a fourth transistor T4 and the first driving voltage line VSL. The first electrode of the light emitting element LE may be connected to the drain electrode of the fourth transistor T4, and the second electrode thereof may be connected to the first driving voltage line VSL. The first electrode of the light emitting element LE may be an anode electrode, and the second electrode of the light emitting element LE may be a cathode electrode. The light emitting element LE may be an organic light emitting diode (OLED) including a first electrode, a second electrode, and an organic light emitting layer disposed between the first electrode and the second electrode, but the present disclosure is not limited thereto. For example, the light emitting element LE may be an inorganic light emitting element including a first electrode, a second electrode, and an inorganic semiconductor disposed between the first electrode and the second electrode, and the light emitting element LE may be, e.g., a micro light emitting diode.

The first transistor T1 may be a driving transistor that controls a driving current flowing between the source electrode and the drain electrode thereof according to a voltage applied to the gate electrode thereof. The first transistor T1 may include a gate electrode connected to a first node N1, a source electrode connected to the drain electrode of a sixth transistor T6, and a drain electrode connected to a second node N2.

A second transistor T2 may be disposed between one electrode of the first capacitor CP1 and the data line DL. The second transistor T2 may be turned on by the write scan signal of the write scan line GWL to connect the one electrode of the first capacitor CP1 to the data line DL. Accordingly, the data voltage of the data line DL may be applied to the one electrode of the first capacitor CP1. The second transistor T2 may include a gate electrode connected to the write scan line GWL, a source electrode connected to the data line DL, and a drain electrode connected to the one electrode of the first capacitor CP1.

A third transistor T3 may be disposed between the first node N1 and the second node N2. The third transistor T3 may be turned on by the write control signal of the control scan line GCL to connect the first node N1 to the second node N2. For this reason, because the gate electrode and the source electrode of the first transistor T1 are connected, the first transistor T1 may operate like a diode (e.g., the first transistor T1 may be diode-connected). The third transistor T3 may include a gate electrode connected to the control scan line GCL, a source electrode connected to the second node N2, and a drain electrode connected to the first node N1.

The fourth transistor T4 may be connected between the second node N2 and a third node N3. The fourth transistor T4 may be turned on by the first emission control signal of the first emission control line EL1 to connect the second node N2 to the third node N3. Accordingly, the driving current of the first transistor T1 may be supplied to the light emitting element LE. The fourth transistor T4 may include a gate electrode connected to the first emission control line EL1, a source electrode connected to the second node N2, and a drain electrode connected to the third node N3.

A fifth transistor T5 may be disposed between the third node N3 and the third driving voltage line VIL. The fifth transistor T5 may be turned on by the bias scan signal of the bias scan line GBL to connect the third node N3 to the third driving voltage line VIL. Accordingly, the third driving voltage VINT of the third driving voltage line VIL may be applied to the first electrode of the light emitting element LE. The fifth transistor T5 may include a gate electrode connected to the bias scan line GBL, a source electrode connected to the third node N3, and a drain electrode connected to the third driving voltage line VIL.

The sixth transistor T6 may be disposed between the source electrode of the first transistor T1 and the second driving voltage line VDL. The sixth transistor T6 may be turned on by the second emission control signal of the second emission control line EL2 to connect the source electrode of the first transistor T1 to the second driving voltage line VDL. Accordingly, the second driving voltage VDD of the second driving voltage line VDL may be applied to the source electrode of the first transistor T1. The sixth transistor T6 may include a gate electrode connected to the second emission control line EL2, a source electrode connected to the second driving voltage line VDL, and a drain electrode connected to the source electrode of the first transistor T1.

The first capacitor CP1 may be disposed between the first node N1 and the drain electrode of the second transistor T2. The first capacitor CP1 may include one electrode connected to the drain electrode of the second transistor T2 and the other electrode connected to the first node N1.

The second capacitor CP2 may be disposed between the gate electrode of the first transistor T1 (e.g., the first node N1) and the second driving voltage line VDL. The second capacitor CP2 may include one electrode connected to the gate electrode of the first transistor T1 (e.g., the first node N1) and the other electrode connected to the second driving voltage line VDL.

The first node N1 may be a junction between the gate electrode of the first transistor T1, the drain electrode of the third transistor T3, the other electrode of the first capacitor CP1, and the one electrode of the second capacitor CP2. The second node N2 may be a junction between the drain electrode of the first transistor T1, the source electrode of the third transistor T3, and the source electrode of the fourth transistor T4. The third node N3 may be a junction between the drain electrode of the fourth transistor T4, the source electrode of the fifth transistor T5, and the first electrode of the light emitting element LE.

Each of the first to sixth transistors T1 to T6 may be a metal-oxide-semiconductor field effect transistor (MOSFET). For example, each of the first to sixth transistors T1 to T6 may be a P-type MOSFET, but the present disclosure is not limited thereto. Each of the first to sixth transistors T1 to T6 may be an N-type MOSFET. Alternatively, some of the first to sixth transistors T1 to T6 may be P-type MOSFETs, and each of the remaining transistors may be an N-type MOSFET.

Although it is illustrated in FIG. 3 that the first sub-pixel SP1 includes six transistors T1 to T6 and two capacitors CP1 and CP2, the equivalent circuit diagram of the first sub-pixel SP1 is not limited to that shown in FIG. 3. For example, the number of the transistors and the number of the capacitors of the first sub-pixel SP1 may be changed in various ways.

Further, the equivalent circuit diagram of the second sub-pixel SP2 and the equivalent circuit diagram of the third sub-pixel SP3 may be substantially the same as the equivalent circuit diagram of the first sub-pixel SP1 described in conjunction with FIG. 3. Therefore, the description of the equivalent circuit diagram of the second sub-pixel SP2 and the equivalent circuit diagram of the third sub-pixel SP3 is omitted in the present specification.

FIG. 4 is a plan view illustrating an example of a display panel according to one or more embodiments.

Referring to FIG. 4, the display area DAA of the display panel 100 according to one or more embodiments may include the plurality of pixels PX arranged in a matrix form. The non-display area NDA of the display panel 100 according to one or more embodiments may include the scan driver 610, the emission driver 620, the data driver 700, a first distribution circuit 710, a second distribution circuit 720, the first pad portion PDA1, and a second pad portion PDA2.

The scan driver 610 may be disposed on the first side of the display area DAA, and the emission driver 620 may be disposed on the second side of the display area DAA. For example, the scan driver 610 may be disposed on the other side of the display area DAA in the first direction DR1, and the emission driver 620 may be disposed on one side of the display area DAA in the first direction DR1. That is, the scan driver 610 may be disposed on the left side of the display area DAA, and the emission driver 620 may be disposed on the right side of the display area DAA. However, the present disclosure is not limited thereto, and the scan driver 610 and the emission driver 620 may be disposed on both the first side and the second side of the display area DAA.

The first pad portion PDA1 may include the plurality of first pads PD1 connected to pads or bumps of the circuit board 300 through a conductive adhesive member. The first pad portion PDA1 may be disposed on the third side of the display area DAA. For example, the first pad portion PDA1 may be disposed on the other side of the display area DAA in the second direction DR2. That is, the first pad portion PDA1 may be disposed on the lower side of the display area DAA.

The first pad portion PDA1 may be disposed outside the data driver 700 in the second direction DR2. That is, the first pad portion PDA1 may be disposed closer to the edge of the display panel 100 than the data driver 700.

The second pad portion PDA2 may include a plurality of second pads PD2 corresponding to inspection pads that test whether the display panel 100 operates normally. The plurality of second pads PD2 may be connected to a jig or a probe pin during an inspection process, or may be connected to a circuit board for inspection. The circuit board for inspection may be a printed circuit board (PCB) made of a rigid material or a flexible printed circuit board (FPCB) made of a flexible material.

The first distribution circuit 710 may distribute data voltages applied through the first pad portion PDA1 to the plurality of data lines DL. For example, the first distribution circuit 710 may distribute the data voltages applied through one first pad PD1 of the first pad portion PDA1 to the P (P is a positive integer of 2 or more) data lines DL, and as a result, the number of the plurality of first pads PD1 may be reduced. The first distribution circuit 710 may be disposed on the third side of the display area DAA of the display panel 100. For example, the first distribution circuit 710 may be disposed on the other side of the display area DAA in the second direction DR2. That is, the first distribution circuit 710 may be disposed on the lower side of the display area DAA.

The second distribution circuit 720 may distribute signals applied through the second pad portion PDA2 to the scan driver 610, the emission driver 620, and the data lines DL. The second pad portion PDA2 and the second distribution circuit 720 may be configured to inspect the operation of each of the pixels PX in the display area DAA. The second distribution circuit 720 may be disposed on the fourth side of the display area DAA of the display panel 100. For example, the second distribution circuit 720 may be disposed on one side of the display area DAA in the second direction DR2. That is, the second distribution circuit 720 may be disposed on the upper side of the display area DAA.

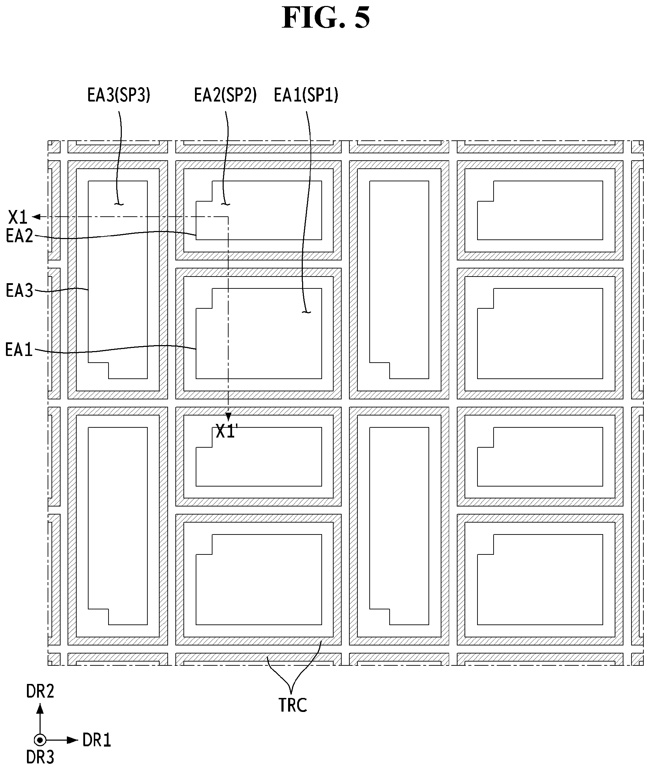

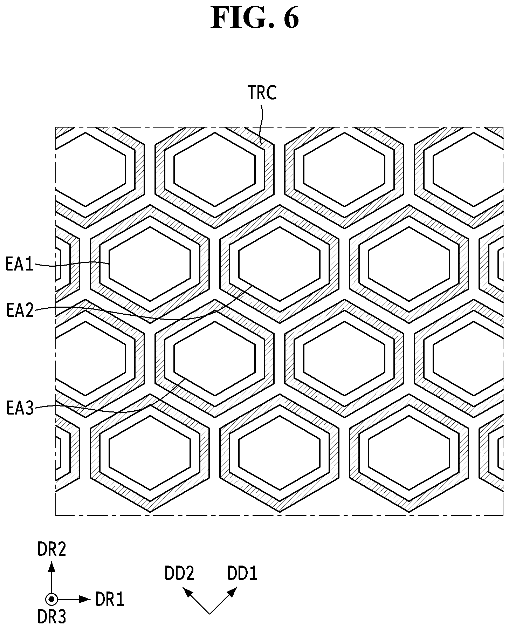

FIGS. 5 and 6 are plan views illustrating one or more embodiments of the display area of FIG. 4.

Referring to FIGS. 5 and 6, each of the pixels PX may include a first emission area EA1 that is an emission area of the first sub-pixel SP1, a second emission area EA2 that is an emission area of the second sub-pixel SP2, and a third emission area EA3 that is an emission area of the third sub-pixel SP3.

In one or more embodiments, as shown in FIGS. 5 and 6, the first emission area EA1, the second emission area EA2, and the third emission area EA3 may have, in a plan view, a hexagonal shape formed of six straight lines, but the present disclosure is not limited thereto. The first emission area EA1, the second emission area EA2, and the third emission area EA3 may have a polygonal shape other than a hexagon, a circular shape, an elliptical shape, or an atypical shape in a plan view.

In one or more embodiments, as shown in FIG. 5, the maximum length of the third emission area EA3 in the first direction DR1 may be smaller than the maximum length of the first emission area EA1 in the first direction DR1 and the maximum length of the second emission area EA2 in the first direction DR1. The maximum length of the first emission area EA1 in the first direction DR1 and the maximum length of the second emission area EA2 in the first direction DR1 may be substantially the same.

In one or more embodiments, as shown in FIG. 5, the maximum length of the third emission area EA3 in the second direction DR2 may be greater than the maximum length of the first emission area EA1 in the second direction DR2 and the maximum length of the second emission area EA2 in the second direction DR2. The maximum length of the first emission area EA1 in the second direction DR2 may be greater than the maximum length of the second emission area EA2 in the second direction DR2.

In one or more embodiments, as shown in FIG. 5, the first emission area EA1 and the second emission area EA2 in each of the plurality of pixels PX may be adjacent to each other in the second direction DR2. The first emission area EA1 and the third emission area EA3 may be adjacent to each other in the first direction DR1. The second emission area EA2 and the third emission area EA3 may be adjacent to each other in the first direction DR1. The area of the first emission area EA1, the area of the second emission area EA2, and the area of the third emission area EA3 may be different.

In one or more embodiments, as shown in FIG. 6, in each of the plurality of pixels PX, the first emission area EA1 and the second emission area EA2 may be adjacent to each other in the first direction DR1, but the second emission area EA2 and the third emission area EA3 may be adjacent to each other in a first diagonal direction DD1, and the first emission area EA1 and the third emission area EA3 may be adjacent to each other in a second diagonal direction DD2.

In the illustrated drawing, the first diagonal direction DD1 intersects each of the first direction DR1 and the second direction DR2 as horizontal directions. For example, the first diagonal direction DD1 may be a direction inclined by 45 degrees with respect to the first direction DR1 and the second direction DR2, but the present disclosure is not limited thereto. The second diagonal direction DD2 intersects each of the first direction DR1 and the second direction DR2 as horizontal directions. For example, the second diagonal direction DD2 may be a direction inclined by 45 degrees with respect to the opposite direction of the first direction DR1 and the second direction DR2, but the present disclosure is not limited thereto. The second diagonal direction DD2 may be a direction perpendicular to the first diagonal direction DD1.

The first emission area EA1 may emit light of a first color, the second emission area EA2 may emit light of a second color, and the third emission area EA3 may emit light of a third color. Here, the light of the first color may be light of a red wavelength band, the light of the second color may be light of a green wavelength band, and the light of the third color may be light of a blue wavelength band. For example, the blue wavelength band may be a wavelength band of light whose main peak wavelength is in the range of about 370 nm to about 460 nm, the green wavelength band may be a wavelength band of light whose main peak wavelength is in the range of about 480 nm to about 560 nm, and the red wavelength band may be a wavelength band of light whose main peak wavelength may be in the range of about 600 nm to about 750 nm.

It is exemplified in FIGS. 5 and 6 that each of the plurality of pixels PX includes three emission areas EA1, EA2, and EA3, but the present disclosure is not limited thereto. That is, each of the plurality of pixels PX may include four or more emission areas.

In addition, the shape and disposition of the emission areas of the plurality of pixels PX are not limited to those illustrated in FIGS. 5 and 6. For example, the emission areas of the plurality of pixels PX may be disposed in a stripe structure in which the emission areas are arranged along the first direction DR1, a PENTILE^{®} structure in which the emission areas are arranged in a diamond shape, or a hexagonal structure in which the emission areas having a hexagonal shape, in a plan view, are arranged side by side as shown in FIG. 6. The PENTILE^{®} pixel arrangement structure may be referred to as an RGBG matrix structure (e.g., a PENTILE^{®} matrix structure or an RGBG structure (e.g., a PENTILE^{®} structure)). PENTILE^{®} is a registered trademark of Samsung Display Co., Ltd., Republic of Korea.

FIG. 7 is a cross-sectional view illustrating an example of a display panel taken along the line X1-X1' of FIG. 5.

Referring to FIG. 7, the display panel 100 may include a semiconductor backplane SBP, a light emitting element backplane EBP, a display element layer EML, an encapsulation layer TFE, an optical layer OPL, a cover layer CVL, and a polarizing plate POL.

The semiconductor backplane SBP may include the semiconductor substrate SSUB including a plurality of pixel transistors PTR, a plurality of semiconductor insulating films covering the plurality of pixel transistors PTR, and a plurality of contact terminals CTE electrically connected to the plurality of pixel transistors PTR, respectively. The plurality of pixel transistors PTR may be the first to sixth transistors T1 to T6 (see FIG. 4) described with reference to FIG. 4.

The semiconductor substrate SSUB may be a silicon substrate, a germanium substrate, and/or a silicon-germanium substrate. The semiconductor substrate SSUB may be a substrate doped with a first type impurity. A plurality of well regions WA may be disposed on the top surface of the semiconductor substrate SSUB. The plurality of well regions WA may be regions doped with a second type impurity. The second type impurity may be different from the aforementioned first type impurity. For example, when the first type impurity is a p-type impurity, the second type impurity may be an n-type impurity. Alternatively, when the first type impurity is an n-type impurity, the second type impurity may be a p-type impurity.

Each of the plurality of well regions WA may include a source region SA corresponding to the source electrode of the pixel transistor PTR, a drain region DA corresponding to the drain electrode thereof, and a channel region CH disposed between the source region SA and the drain region DA.

A lower insulating film BINS may be disposed between a gate electrode GE and the well region WA. A side insulating film SINS may be disposed on the side surface of the gate electrode GE. The side insulating film SINS may be disposed on the lower insulating film BINS.

Each of the source region SA and the drain region DA may be a region doped with the first type impurity. The gate electrode GE of the pixel transistor PTR may overlap the well region WA in the third direction DR3. The channel region CH may overlap the gate electrode GE in the third direction DR3. The source region SA may be disposed on one side of the gate electrode GE, and the drain region DA may be disposed on the other side of the gate electrode GE.

Each of the plurality of well regions WA may further include a first low-concentration impurity region LDD1 disposed between the channel region CH and the source region SA, and a second low-concentration impurity region LDD2 disposed between the channel region CH and the drain region DA. The first low-concentration impurity region LDD1 may be a region having a lower impurity concentration than the source region SA due to the lower insulating film BINS. The second low-concentration impurity region LDD2 may be a region having a lower impurity concentration than the drain region DA due to the lower insulating film BINS. The distance between the source region SA and the drain region DA may increase due to the presence of the first low-concentration impurity region LDD1 and the second low-concentration impurity region LDD2. Therefore, the length of the channel region CH of each of the pixel transistors PTR increases, so that punch-through and hot carrier phenomena that might be caused by a short channel are prevented.

A first semiconductor insulating film SINS1 may be disposed on the semiconductor substrate SSUB and the pixel transistors PTR. The first semiconductor insulating film SINS1 may be formed of silicon carbonitride (SiCN) and/or a silicon oxide (SiOx)-based inorganic film, but the present disclosure is not limited thereto.

A second semiconductor insulating film SINS2 may be disposed on the first semiconductor insulating film SINS1. The second semiconductor insulating film SINS2 may be formed of a silicon oxide (SiOx)-based inorganic film, but the present disclosure is not limited thereto.

The plurality of contact terminals CTE may be disposed on the second semiconductor insulating film SINS2. Each of the plurality of contact terminals CTE may be connected to one of the gate electrode GE, the source region SA, and the drain region DA of each of the pixel transistors PTR through holes penetrating the first semiconductor insulating film SINS1 and the second semiconductor insulating film SINS2. The plurality of contact terminals CTE may be formed of copper (Cu), aluminium (Al), tungsten (W), molybdenum (Mo), chromium (Cr), gold (Au), titanium (Ti), nickel (Ni), and/or neodymium (Nd), and/or an alloy including one or more of them.

A third semiconductor insulating film SINS3 may be disposed on a side surface of each of the plurality of contact terminals CTE. The top surface of each of the plurality of contact terminals CTE may be exposed without being covered by the third semiconductor insulating film SINS3. The third semiconductor insulating film SINS3 may be formed of a silicon oxide (SiOx)-based inorganic film, but the present disclosure is not limited thereto.

The semiconductor substrate SSUB may be replaced with a glass substrate or a polymer resin substrate such as polyimide. In this case, thin film transistors may be disposed on the glass substrate or the polymer resin substrate. The glass substrate may be a rigid substrate that does not bend, and the polymer resin substrate may be a flexible substrate that can be bent or curved.

The light emitting element backplane EBP may include a plurality of conductive layers ML1 to ML8, a plurality of vias VA1 to VA9, and a plurality of insulating films INS1 to INS9.

The first to eighth conductive layers ML1 to ML8 serve to connect the plurality of contact terminals CTE exposed from the semiconductor backplane SBP to thereby implement the pixel circuit of the first sub-pixel SP1 shown in FIG. 4. For example, the first to sixth transistors T1 to T6 are merely disposed on the semiconductor backplane SBP, and the connection line of the first to sixth transistors T1 to T6 and the first capacitor CP1 and the second capacitor CP2 may be disposed in the first to eighth conductive layers ML1 to ML8. In addition, a connection portion between the drain region corresponding to the drain electrode of the fourth transistor T4, the source region corresponding to the source electrode of the fifth transistor T5, and the first electrode of the light emitting element LE may also be disposed in the first to eighth conductive layers ML1 to ML8.

The first insulating film INS1 may be disposed on the semiconductor backplane SBP. Each of the first vias VA1 may penetrate the first insulating film INS1 to be connected to the contact terminal CTE exposed from the semiconductor backplane SBP. Each of the first conductive layers ML1 may be disposed on the first insulating film INS1 and may be connected to the first via VA1.

The second insulating film INS2 may be disposed on the first insulating film INS1 and the first conductive layers ML1. Each of the second vias VA2 may penetrate the second insulating film INS2 and may be connected to the exposed first conductive layer ML1. Each of the second conductive layers ML2 may be disposed on the second insulating film INS2 and may be connected to the second via VA2.

The third insulating film INS3 may be disposed on the second insulating film INS2 and the second conductive layers ML2. Each of the third vias VA3 may penetrate the third insulating film INS3 and may be connected to the exposed second conductive layer ML2. Each of the third conductive layers ML3 may be disposed on the third insulating film INS3 and may be connected to the third via VA3.

A fourth insulating film INS4 may be disposed on the third insulating film INS3 and the third conductive layers ML3. Each of the fourth vias VA4 may penetrate the fourth insulating film INS4 and may be connected to the exposed third conductive layer ML3. Each of the fourth conductive layers ML4 may be disposed on the fourth insulating film INS4 and may be connected to the fourth via VA4.

A fifth insulating film INS5 may be disposed on the fourth insulating film INS4 and the fourth conductive layers ML4. Each of the fifth vias VA5 may penetrate the fifth insulating film INS5 and may be connected to the exposed fourth conductive layer ML4. Each of the fifth conductive layers ML5 may be disposed on the fifth insulating film INS5 and may be connected to the fifth via VA5.

A sixth insulating film INS6 may be disposed on the fifth insulating film INS5 and the fifth conductive layers ML5. Each of the sixth vias VA6 may penetrate the sixth insulating film INS6 and may be connected to the exposed fifth conductive layer ML5. Each of the sixth conductive layers ML6 may be disposed on the sixth insulating film INS6 and may be connected to the sixth via VA6.

A seventh insulating film INS7 may be disposed on the sixth insulating film INS6 and the sixth conductive layers ML6. Each of the seventh vias VA7 may penetrate the seventh insulating film INS7 and may be connected to the exposed sixth conductive layer ML6. Each of the seventh conductive layers ML7 may be disposed on the seventh insulating film INS7 and may be connected to the seventh via VA7.

An eighth insulating film INS8 may be disposed on the seventh insulating film INS7 and the seventh conductive layers ML7. Each of the eighth vias VA8 may penetrate the eighth insulating film INS8 and may be connected to the exposed seventh conductive layer ML7. Each of the eighth conductive layers ML8 may be disposed on the eighth insulating film INS8 and may be connected to the eighth via VA8.

The first to eighth conductive layers ML1 to ML8 and the first to eighth vias VA1 to VA8 may be formed of substantially the same material. The first to eighth conductive layers ML1 to ML8 and the first to eighth vias VA1 to VA8 may be formed of copper (Cu), aluminium (Al), tungsten (W), molybdenum (Mo), chromium (Cr), gold (Au), titanium (Ti), nickel (Ni), and/or neodymium (Nd), and/or an alloy including any one of them. First to eighth insulating films INS1 to INS8 may be formed of a silicon oxide (SiOx)-based inorganic film, but the present disclosure is not limited thereto.

The thicknesses of the first conductive layer ML1, the second conductive layer ML2, the third conductive layer ML3, the fourth conductive layer ML4, the fifth conductive layer ML5, and the sixth conductive layer ML6 may be greater than the thicknesses of the first via VA1, the second via VA2, the third via VA3, the fourth via VA4, the fifth via VA5, and the sixth via VA6, respectively. The thickness of each of the second conductive layer ML2, the third conductive layer ML3, the fourth conductive layer ML4, the fifth conductive layer ML5, and the sixth conductive layer ML6 may be greater than the thickness of the first conductive layer ML1. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be substantially the same. For example, the thickness of the first conductive layer ML1 may be approximately 1360 Å; the thickness of each of the second conductive layer ML2, the third conductive layer ML3, the fourth conductive layer ML4, the fifth conductive layer ML5, and the sixth conductive layer ML6 may be approximately 1440 Å; and the thickness of each of the first via VA1, the second via VA2, the third via VA3, the fourth via VA4, the fifth via VA5, and the sixth via VA6 may be approximately 1150 Å. However, the thicknesses of the first to sixth conductive layers ML1, ML2, ML3, ML4, ML5, and ML6 and the first to sixth vias VA1, VA2, VA3, VA4, VA5, and VA6 are not limited thereto.

The thickness of each of the seventh conductive layer ML7 and the eighth conductive layer ML8 may be greater than the thickness of the first conductive layer ML1, the thickness of the second conductive layer ML2, the thickness of the third conductive layer ML3, the thickness of the fourth conductive layer ML4, the thickness of the fifth conductive layer ML5, and the thickness of the sixth conductive layer ML6. The thickness of the seventh conductive layer ML7 and the thickness of the eighth conductive layer ML8 may be greater than the thickness of the seventh via VA7 and the thickness of the eighth via VA8, respectively. The thickness of each of the seventh via VA7 and the eighth via VA8 may be greater than the thickness of the first via VA1, the thickness of the second via VA2, the thickness of the third via VA3, the thickness of the fourth via VA4, the thickness of the fifth via VA5, and the thickness of the sixth via VA6. The thickness of the seventh conductive layer ML7 and the thickness of the eighth conductive layer ML8 may be substantially the same. For example, the thickness of each of the seventh conductive layer ML7 and the eighth conductive layer ML8 may be approximately 9000 Å, and the thickness of each of the seventh via VA7 and the eighth via VA8 may be approximately 6000 Å. However, the thicknesses of the seventh conductive layer ML7, the eighth conductive layer ML8, the seventh via VA7, and the eighth via VA8 are not limited thereto.

A ninth insulating film INS9 may be disposed on the eighth insulating film INS8 and the eighth conductive layer ML8. The ninth insulating film INS9 may be formed of a silicon oxide (SiOx)-based inorganic film, but the present disclosure is not limited thereto.

Each of the ninth vias VA9 may penetrate the ninth insulating film INS9 and may be connected to the exposed eighth conductive layer ML8. The ninth vias VA9 may be formed of copper (Cu), aluminium (Al), tungsten (W), molybdenum (Mo), chromium (Cr), gold (Au), titanium (Ti), nickel (Ni), and/or neodymium (Nd), and/or an alloy including one or more of them. The thickness of the ninth via VA9 may be approximately 16500 Å. However, the thickness of the ninth via VA9 is not limited thereto.

The display element layer EML may be disposed on the light emitting element backplane EBP. The display element layer EML may include light emitting elements LE each including a reflective electrode layer RL, tenth and eleventh insulating films INS10 and INS11, a tenth via VA10, a first electrode AND, a light emitting stack IL, and a second electrode CAT; a pixel defining film PDL; and a plurality of trenches TRC.

The reflective electrode layer RL may be disposed on the ninth insulating film INS9. The reflective electrode layer RL may include at least one reflective electrode RL1, RL2, RL3, and RL4. For example, the reflective electrode layer RL may include first to fourth reflective electrodes RL1, RL2, RL3, and RL4 as shown in FIG. 7, but is not limited thereto.

Each of the first reflective electrodes RL1 may be disposed on the ninth insulating film INS9, and may be connected to the ninth via VA9. The first reflective electrodes RL1 may be formed of copper (Cu), aluminium (Al), tungsten (W), molybdenum (Mo), chromium (Cr), gold (Au), titanium (Ti), nickel (Ni), and/or neodymium (Nd), and/or an alloy including one or more of them. For example, the first reflective electrodes RL1 may include titanium nitride (TiN).

Each of the second reflective electrodes RL2 may be disposed on the first reflective electrode RL1. The second reflective electrodes RL2 may be formed of copper (Cu), aluminium (Al), tungsten (W), molybdenum (Mo), chromium (Cr), gold (Au), titanium (Ti), nickel (Ni), and/or neodymium (Nd), and/or an alloy including one or more of them. For example, the second reflective electrodes RL2 may include aluminium (Al).

Each of the third reflective electrodes RL3 may be disposed on the second reflective electrode RL2. The third reflective electrodes RL3 may be formed of copper (Cu), aluminium (Al), tungsten (W), molybdenum (Mo), chromium (Cr), gold (Au), titanium (Ti), nickel (Ni), and/or neodymium (Nd), and/or an alloy including one or more of them. For example, the third reflective electrodes RL3 may include titanium nitride (TiN).

Each of the fourth reflective electrodes RL4 may be disposed on the third reflective electrode RL3. The fourth reflective electrodes RL4 may be formed of copper (Cu), aluminium (Al), tungsten (W), molybdenum (Mo), chromium (Cr), gold (Au), titanium (Ti), nickel (Ni), and/or neodymium (Nd), and/or an alloy including one or more of them. For example, the fourth reflective electrodes RL4 may include titanium (Ti).

Because, in one or more embodiments, the second reflective electrode RL2 is an electrode that substantially reflects light from the light emitting elements LE, the thickness of the second reflective electrode RL2 may be greater than the thickness of each of the first reflective electrode RL1, the third reflective electrode RL3, and the fourth reflective electrode RL4. For example, the thickness of each of the first reflective electrode RL1, the third reflective electrode RL3, and the fourth reflective electrode RL4 may be approximately 100 Å, and the thickness of the second reflective electrode RL2 may be approximately 850 Å. However, the thicknesses of the first to fourth reflective electrodes RL1, RL2, RL3, and RL4 are not limited thereto. In one or more embodiments, the thickness of the fourth reflective electrode RL4 may be greater than the thickness of each of the first reflective electrode RL1, the second reflective electrode RL2, and the third reflective electrode RL3.

The tenth insulating film INS10 may be disposed on the ninth insulating film INS9. The tenth insulating film INS10 may be disposed between the reflective electrode layers RL adjacent to each other in a horizontal direction. The tenth insulating film INS10 may be formed of a silicon oxide (SiOx)-based inorganic film, but the present disclosure is not limited thereto. In one or more embodiments, the tenth insulating film INS10 may be disposed not only between the reflective electrode layers RL but also on the reflective electrode layer RL.

The eleventh insulating film INS11 may be disposed on the tenth insulating film INS10 and the reflective electrode layer RL. The eleventh insulating film INS11 may be formed of a silicon oxide (SiOx)-based inorganic film, but the present disclosure is not limited thereto. The tenth insulating film INS10 and the eleventh insulating film INS11 may be an optical auxiliary layer through which light reflected by the reflective electrode layer RL passes, from among light emitted from the light emitting elements LE.

In one or more embodiments, in at least one sub-pixel from among the first sub-pixel SP1, the second sub-pixel SP2, and the third sub-pixel SP3, in order to adjust the resonance distance of light emitted from the light emitting elements LE, the total thickness of the insulating film disposed between the first electrode AND and the reflective electrode layer RL may be different in the first sub-pixel SP1, the second sub-pixel SP2, and the third sub-pixel SP3.

In one or more embodiments, as shown in the drawing, when the tenth insulating film INS10 is not disposed between the first electrode AND and the reflective electrode layer RL but the eleventh insulating film INS11 is disposed therebetween, the thickness of the eleventh insulating film INS11 disposed in each of the first sub-pixel SP1, the second sub-pixel SP2, and the third sub-pixel SP3 may be different. For example, the thickness of the eleventh insulating film INS11 disposed in the first sub-pixel SP1 may be smaller than the thickness of the eleventh insulating film INS11 disposed in the second sub-pixel SP2, and the thickness of the eleventh insulating film INS11 disposed in the second sub-pixel SP2 may be smaller than the thickness of the eleventh insulating film INS11 disposed in the third sub-pixel SP3.

In one or more embodiments, in the first sub-pixel SP1, neither the tenth insulating film INS10 nor the eleventh insulating film INS11 may be disposed between the first electrode AND and the reflective electrode layer RL, and in the second sub-pixel SP2, any one of the tenth insulating film INS10 and the eleventh insulating film INS11 may be disposed between the first electrode AND and the reflective electrode layer RL, and in the third sub-pixel SP3, both the tenth insulating film INS10 and the eleventh insulating film INS11 may be disposed between the first electrode AND and the reflective electrode layer RL.

In another embodiment, a twelfth insulating film may be further disposed between the first electrode AND and the reflective electrode layer RL. In this case, in the first sub-pixel SP1, any one of the tenth insulating film INS10, the eleventh insulating film INS11, and the twelfth insulating film may be disposed between the first electrode AND and the reflective electrode layer RL, in the second sub-pixel SP2, any two of the tenth insulating film INS10, the eleventh insulating film INS11, and the twelfth insulating film may be disposed between the first electrode AND and the reflective electrode layer RL, and in the third sub-pixel SP3, all the tenth insulating film INS10, the eleventh insulating film INS11, and the twelfth insulating film may be disposed between the first electrode AND and the reflective electrode layer RL.

In summary, the distance between the first electrode AND and the reflective electrode layer RL may be different in the first sub-pixel SP1, the second sub-pixel SP2, and the third sub-pixel SP3. That is, in order to adjust the distance from the reflective electrode layer RL to the second electrode CAT according to the main wavelength of the light emitted from each of the first sub-pixel SP1, the second sub-pixel SP2, and the third sub-pixel SP3, the presence/absence or thickness of the tenth insulating film INS10 and the eleventh insulating film INS11 may be set in each of the first sub-pixel SP1, the second sub-pixel SP2, and the third sub-pixel SP3.

Although it is illustrated in the drawing that the total thickness of the insulating film disposed between the first electrode AND and the reflective electrode layer RL increases in the order of the first sub-pixel SP1, the second sub-pixel SP2, and the third sub-pixel SP3, the present disclosure is not limited thereto. That is, it is illustrated that the distance between the first electrode AND and the reflective electrode layer RL in the third sub-pixel SP3 is greater than the distance between the first electrode AND and the reflective electrode layer RL in the second sub-pixel SP2 and the distance between the first electrode AND and the reflective electrode layer RL in the first sub-pixel SP1, and the distance between the first electrode AND and the reflective electrode layer RL in the second sub-pixel SP2 is greater than the distance between the first electrode AND and the reflective electrode layer RL in the first sub-pixel SP1, but the present disclosure is not limited thereto. The size relationship of the total thickness of the insulating film disposed between the first electrode AND and the reflective electrode layer RL in each of the first sub-pixel SP1, the second sub-pixel SP2, and the third sub-pixel SP3 may be variously changed depending on the resonance distance.

Each of the tenth vias VA10 may be connected to the reflective electrode layer RL exposed through the tenth insulating film INS10 and/or the eleventh insulating film INS11. The tenth vias VA10 may be formed of copper (Cu), aluminium (Al), tungsten (W), molybdenum (Mo), chromium (Cr), gold (Au), titanium (Ti), nickel (Ni), and/or neodymium (Nd), and/or an alloy including one or more of them. The thickness of the tenth via VA10 in the second sub-pixel SP2 may be smaller than the thickness of the tenth via VA10 in the third sub-pixel SP3, and the thickness of the tenth via VA10 in the first sub-pixel SP1 may be smaller than the thickness of the tenth via VA10 in the second sub-pixel SP2, but the present disclosure is not limited thereto.

The first electrode AND of each of the light emitting elements LE may be disposed on the eleventh insulating film INS11 and connected to the tenth via VA10. The first electrode AND of each of the light emitting elements LE may be connected to the drain region DA or source region SA of the pixel transistor PTR through the tenth via VA10, the first to fourth reflective electrodes RL1 to RL4, the first to ninth vias VA1 to VA9, the first to eighth conductive layers ML1 to ML8, and the contact terminal CTE. The first electrode AND of each of the light emitting elements LE may be formed of copper (Cu), aluminium (Al), tungsten (W), molybdenum (Mo), chromium (Cr), gold (Au), titanium (Ti), nickel (Ni), and/or neodymium (Nd), and/or an alloy including one or more of them. For example, the first electrode AND of each of the light emitting elements LE may be titanium nitride (TiN).

The pixel defining film PDL may be disposed on a part of the first electrode AND of each of the light emitting elements LE. The pixel defining film PDL may cover the edge of the first electrode AND of each of the light emitting elements LE. The pixel defining film PDL may serve to partition the first emission areas EA1, the second emission areas EA2, and the third emission areas EA3.

The first emission area EA1 may be defined as an area in which the first electrode AND, the light emitting stack IL, and the second electrode CAT are sequentially stacked in the first sub-pixel SP1 to emit light. The second emission area EA2 may be defined as an area in which the first electrode AND, the light emitting stack IL, and the second electrode CAT are sequentially stacked in the second sub-pixel SP2 to emit light. The third emission area EA3 may be defined as an area in which the first electrode AND, the light emitting stack IL, and the second electrode CAT are sequentially stacked in the third sub-pixel SP3 to emit light.

The pixel defining film PDL may include first to third pixel defining films PDL1, PDL2, and PDL3. The first pixel defining film PDL1 may be disposed on the edge of the first electrode AND of each of the light emitting elements LE, the second pixel defining film PDL2 may be disposed on the first pixel defining film PDL1, and the third pixel defining film PDL3 may be disposed on the second pixel defining film PDL2. The first pixel defining film PDL1, the second pixel defining film PDL2, and the third pixel defining film PDL3 may be formed of a silicon oxide (SiOₓ)-based inorganic layer, but the present disclosure is not limited thereto. The first pixel defining film PDL1, the second pixel defining film PDL2, and the third pixel defining film PDL3 may each have a thickness of about 500 Å.

When the first pixel defining film PDL1, the second pixel defining film PDL2, and the third pixel defining film PDL3 are formed as one pixel defining film, the height of the one pixel defining film increases, so that a first encapsulation inorganic film TFE1 may be cut off due to step coverage. Step coverage refers to the ratio of the degree of thin film coated on an inclined portion to the degree of thin film coated on a flat portion. The lower the step coverage, the more likely it is that the thin film will be cut off at inclined portions.

Therefore, in order to prevent the first encapsulation inorganic film TFE1 from being cut off due to the step coverage, the first pixel defining film PDL1, the second pixel defining film PDL2, and the third pixel defining film PDL3 may have a cross-sectional structure having a stepped portion. For example, the width of the first pixel defining film PDL1 may be greater than the width of the second pixel defining film PDL2 and the width of the third pixel defining film PDL3, and the width of the second pixel defining film PDL2 may be greater than the width of the third pixel defining film PDL3. Each of the width of the first pixel defining film PDL1, the width of the second pixel defining film PDL2, and the width of the third pixel defining film PDL3 refers to the length in the horizontal direction perpendicular to the third direction DR3.

Each of the plurality of trenches TRC may penetrate the first pixel defining film PDL1, the second pixel defining film PDL2, and the third pixel defining film PDL3. Furthermore, each of the plurality of trenches TRC may penetrate the eleventh insulating film INS11. The eleventh insulating film INS11 may be partially recessed at each of the plurality of trenches TRC.

At least one trench TRC may be disposed between adjacent sub-pixels SP1, SP2, and SP3. Although FIG. 7 illustrates that two trenches TRC are disposed between adjacent sub-pixels SP1, SP2, and SP3, the present disclosure is not limited thereto.

The light emitting stack IL may include a plurality of intermediate layers. FIG. 7 illustrates that the light emitting stack IL has a three-tandem structure including a first stack layer IL1, a second stack layer IL2, and a third stack layer IL3, but the present disclosure is not limited thereto. For example, the light emitting stack IL may have a two-tandem structure including two intermediate layers.

In the three-tandem structure, the light emitting stack IL may have a tandem structure including a plurality of stack layers IL1, IL2, and IL3 that emit different lights. For example, the light emitting stack IL may include the first stack layer IL1 that emits light of the first color, the second stack layer IL2 that emits light of the third color, and the third stack layer IL3 that emits light of the second color. The first stack layer IL1, the second stack layer IL2, and the third stack layer IL3 may be sequentially stacked.

The first stack layer IL1 may have a structure in which a first hole transport layer, a first organic light emitting layer that emits light of the first color, and a first electron transport layer are sequentially stacked. The second stack layer IL2 may have a structure in which a second hole transport layer, a second organic light emitting layer that emits light of the third color, and a second electron transport layer are sequentially stacked. The third stack layer IL3 may have a structure in which a third hole transport layer, a third organic light emitting layer that emits light of the second color, and a third electron transport layer are sequentially stacked.

A first charge generation layer for supplying charges to the second stack layer IL2 and supplying electrons to the first stack layer IL1 may be disposed between the first stack layer IL1 and the second stack layer IL2. The first charge generation layer may include an N-type charge generation layer that supplies electrons to the first stack layer IL1 and a P-type charge generation layer that supplies holes to the second stack layer IL2. The N-type charge generation layer may include a dopant of a metal material.

A second charge generation layer for supplying charges to the third stack layer IL3 and supplying electrons to the second stack layer IL2 may be disposed between the second stack layer IL2 and the third stack layer IL3. The second charge generation layer may include an N-type charge generation layer that supplies electrons to the second stack layer IL2 and a P-type charge generation layer that supplies holes to the third stack layer IL3.

The first stack layer IL1 may be disposed on the first electrodes AND and the pixel defining film PDL, and may be disposed on the bottom surface of each trench TRC. Due to the trench TRC, the first stack layer IL1 may be cut off between adjacent sub-pixels SP1, SP2, and SP3. The second stack layer IL2 may be disposed on the first stack layer IL1. Due to the trench TRC, the second stack layer IL2 may be cut off between adjacent sub-pixels SP1, SP2, and SP3. A cavity ESS or an empty space may be disposed between the first stack layer IL1 and the second stack layer IL2. The third stack layer IL3 may be disposed on the second stack layer IL2. The third stack layer IL3 is not cut off by the trench TRC and may be disposed to cover the second stack layer IL2 in each of the trenches TRC. That is, in the three-tandem structure, each of the plurality of trenches TRC may be a structure for cutting off the first and second stack layers IL1 and IL2, the first charge generation layer, and the second charge generation layer of the display element layer EML between the sub-pixels SP1, SP2, and SP3 adjacent to each other. In addition, in the two-tandem structure, each of the trenches TRC may be a structure for cutting off the charge generation layer disposed between a lower intermediate layer and an upper intermediate layer, and the lower intermediate layer.

In order to stably cut off the first and second stack layers IL1 and IL2 of the display element layer EML between adjacent sub-pixels SP1, SP2, and SP3, the height of each of the plurality of trenches TRC may be greater than the height of the pixel defining film PDL. The height of each of the plurality of trenches TRC refers to the length of each of the plurality of trenches TRC in the third direction DR3. The height of the pixel defining film PDL refers to the length of the pixel defining film PDL in the third direction DR3. In order to cut off the first to third stack layers IL1, IL2, and IL3 of the display element layer EML between the neighboring sub-pixels SP1, SP2, and SP3, another structure may exist instead of the trench TRC. For example, instead of the trench TRC, a reverse tapered partition wall may be disposed on the pixel defining film PDL.

The number of the stack layers IL1, IL2, and IL3 that emit different lights is not limited to that shown in FIG. 7. For example, the light emitting stack IL may include two intermediate layers. In this case, one of the two intermediate layers may be substantially the same as the first stack layer IL1, and the other may include a second hole transport layer, a second organic light emitting layer, a third organic light emitting layer, and a second electron transport layer. In this case, a charge generation layer for supplying electrons to one intermediate layer and supplying charges to the other intermediate layer may be disposed between the two intermediate layers.

In addition, FIG. 7 illustrates that the first to third stack layers IL1, IL2, and IL3 are all disposed in the first emission area EA1, the second emission area EA2, and the third emission area EA3, but the present disclosure is not limited thereto. For example, the first stack layer IL1 may be disposed in the first emission area EA1, and may not be disposed in the second emission area EA2 and the third emission area EA3. Furthermore, the second stack layer IL2 may be disposed in the second emission area EA2 and may not be disposed in the first emission area EA1 and the third emission area EA3. Further, the third stack layer IL3 may be disposed in the third emission area EA3 and may not be disposed in the first emission area EA1 and the second emission area EA2. In this case, a plurality of color filters CF1, CF2, and CF3 of the optical layer OPL may be omitted.

The second electrode CAT may be disposed on the third stack layer IL3. The second electrode CAT may be disposed on the third stack layer IL3 in each of the plurality of trenches TRC. The second electrode CAT may be formed of a transparent conductive material (TCO) such as ITO and/or IZO that can transmit light or a semi-transmissive conductive material such as magnesium (Mg), silver (Ag), or an alloy of magnesium (Mg) and silver (Ag). When the second electrode CAT is formed of a semi-transmissive conductive material, the light emission efficiency may be improved in each of the first to third sub-pixels SP1, SP2, and SP3 due to a micro-cavity effect.

The encapsulation layer TFE may be disposed on the display element layer EML. The encapsulation layer TFE may include at least one inorganic film TFE1 and TFE2 to prevent oxygen and/or moisture from permeating into the display element layer EML. For example, the encapsulation layer TFE may include the first encapsulation inorganic film TFE1, and a second encapsulation inorganic film TFE2.

The first encapsulation inorganic film TFE1 may be disposed on the second electrode CAT. The first encapsulation inorganic film TFE1 may be formed as a multilayer in which one or more inorganic films selected from silicon nitride (SiNx), silicon oxy nitride (SiON), and/or silicon oxide (SiOx) are alternately stacked. The first encapsulation inorganic film TFE1 may be formed by a chemical vapor deposition (CVD) process.

The second encapsulation inorganic film TFE2 may be disposed on the first encapsulation inorganic film TFE1. The second encapsulation inorganic film TFE2 may be formed of titanium oxide (TiOx) and/or aluminium oxide (AlOx), but the present disclosure is not limited thereto. The second encapsulation inorganic film TFE2 may be formed by an atomic layer deposition (ALD) process. The thickness of the second encapsulation inorganic film TFE2 may be smaller than the thickness of the first encapsulation inorganic film TFE1.

The display panel 100 may further include an organic film APL. An organic film APL may be a layer for increasing the interfacial adhesion between the encapsulation layer TFE and the optical layer OPL. The organic film APL may be an organic film such as acrylic resin, epoxy resin, phenolic resin, polyamide resin, and/or polyimide resin.

The optical layer OPL may include a color filter layer CFL, a first filling layer FIL1, a base layer BAS, a nano pattern layer NPL, and a second filling layer FIL2. The color filter layer CFL may include a first color filter CF1, a second color filter CF2, and a third color filter CF3. The plurality of color filters CF1, CF2, and CF3 may be disposed on the organic film APL.

The first color filter CF1 may overlap the first emission area EA1 of the first sub-pixel SP1. The first color filter CF1 may transmit light of the first color, i.e., light of a red wavelength band. The red wavelength band may be a wavelength band of approximately 600 nm to 750 nm. Thus, the first color filter CF1 may transmit light of the first color from among light emitted from the first emission area EA1.

The second color filter CF2 may overlap the second emission area EA2 of the second sub-pixel SP2. The second color filter CF2 may transmit light of the second color, i.e., light of a green wavelength band. The green wavelength band may be a wavelength band of approximately 480 nm to 560 nm. Thus, the second color filter CF2 may transmit light of the second color from among light emitted from the second emission area EA2.

The third color filter CF3 may overlap the third emission area EA3 of the third sub-pixel SP3. The third color filter CF3 may transmit light of the third color, i.e., light of a blue wavelength band. The blue wavelength band may be a wavelength band of approximately 370 nm to 460 nm. Thus, the third color filter CF3 may transmit light of the third color from among light emitted from the third emission area EA3.

The first filling layer FIL1 may be disposed on the color filter layer CFL. The first filling layer FIL1 may have a suitable refractive index (e.g., a predetermined refractive index) such that light travels in the third direction DR3 at an interface between the first filling layer FIL1 and the color filter layer CFL. Further, first filling layer FIL1 may be a planarization layer. The first filling layer FIL1 may be an organic film such as acrylic resin, epoxy resin, phenolic resin, polyamide resin, and/or polyimide resin.

The base layer BAS may be disposed on the first filling layer FIL1. The base layer BAS may include a transparent material having high transmittance to allow light emitted from the display element layer EML to pass therethrough. In one or more embodiments, the base layer BAS may include glass that is rigid. In another embodiment, the base layer BAS may include an insulating material of a polymer resin such as polyimide, which has a flexible property capable of being subjected to bending, folding, rolling, and/or the like. In another embodiment, the base layer BAS may include a Group III to Group V compound semiconductor crystal such as gallium phosphide (GaP), aluminium gallium arsenide (AlGaAs), and/or gallium nitride (GaN), a Group II to Group VI semiconductor crystal such as zinc sulfide (ZnS) and/or zinc selenide (ZnSe), and a Group IV semiconductor crystal such as hexagonal and/or cubic silicon carbide (SiC).

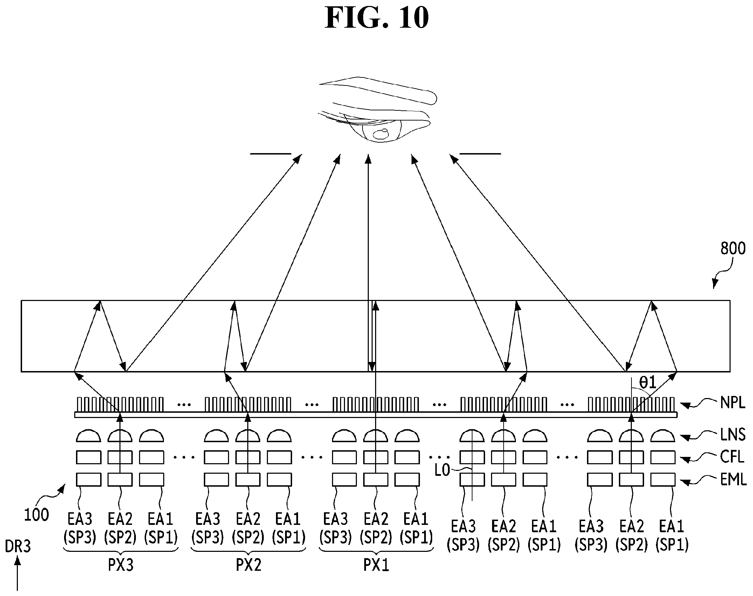

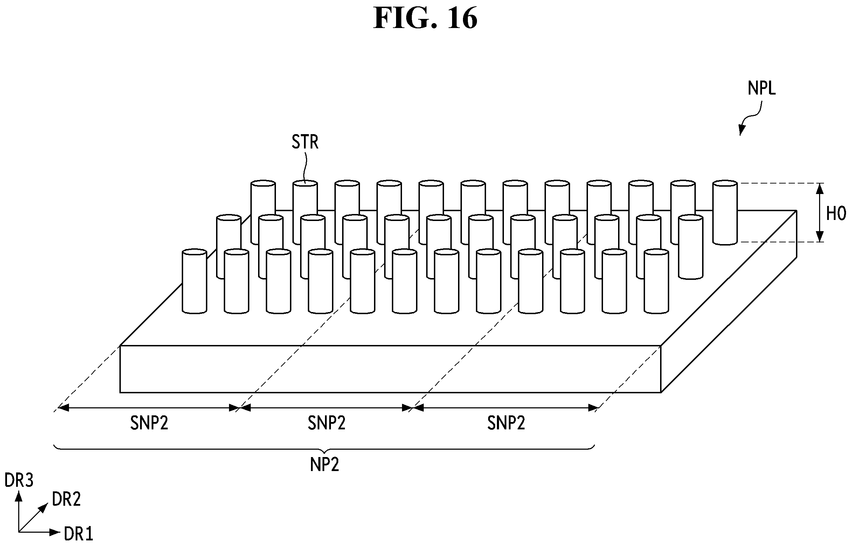

The nano pattern layer NPL may be disposed on the base layer BAS. The nano pattern layer NPL may include a plurality of nano patterns NP. The plurality of nano patterns NP of the nano pattern layer NPL may implement a meta-surface. For example, the plurality of nano patterns NP may change the path of light by diffracting the light emitted from the display element layer EML. The nano pattern NP may include a plurality of nano structures STR (see FIG. 16). The nano pattern NP will be described later with reference to FIG. 10.

In the present specification, the nano pattern refers to a pattern formed of a microscopic structure of level of nanometer or sub-nanometer. The level of nanometer or sub-nanometer includes units smaller than nanometers, such as picometers (10⁻¹²m) and femtometers (10⁻¹⁵m), as well nanometers.

The second filling layer FIL2 may be disposed on the nano pattern layer NPL. The second filling layer FIL2 may be disposed on the base layer BAS. The second filling layer FIL2 may be an organic film such as acrylic resin, epoxy resin, phenolic resin, polyamide resin, and/or polyimide resin.

The cover layer CVL may be disposed on the second filling layer FIL2. The cover layer CVL may be a polymer resin such as a glass substrate and/or a resin. In the case where the cover layer CVL is a glass substrate, the cover layer CVL may be attached on the second filling layer FIL2. In this case, the second filling layer FIL2 may serve to attach the cover layer CVL. In the case where the cover layer CVL is a glass substrate, the cover layer CVL may serve as an encapsulation substrate. In the case where the cover layer CVL is a polymer resin such as a resin, the cover layer CVL may be directly applied on the second filling layer FIL2.

The polarizing plate POL may be disposed on one surface of the cover layer CVL. The polarizing plate POL may be a structure for preventing visibility degradation caused by reflection of external light. The polarizing plate POL may include a linear polarizing plate and a phase retardation film. For example, the phase retardation film may be a λ/4 plate (quarter-wave plate), but the present disclosure is not limited thereto. However, when visibility degradation caused by reflection of external light is sufficiently overcome by the plurality of color filters CF1, CF2, and CF3, the polarizing plate POL may be omitted.

Although the polarizing plate POL is illustrated as being mounted in the display panel 100 in the drawing, the present disclosure is not limited thereto. For example, the polarizing plate POL may include an optical module 800 (see FIG. 11) to be described later, and in this case, the polarizing plate POL may be the same component as the optical module 800 (see FIG. 11). That is, the polarizing plate POL may be provided by being mounted in the display panel 100 or being mounted in the optical module 800 (see FIG. 11).

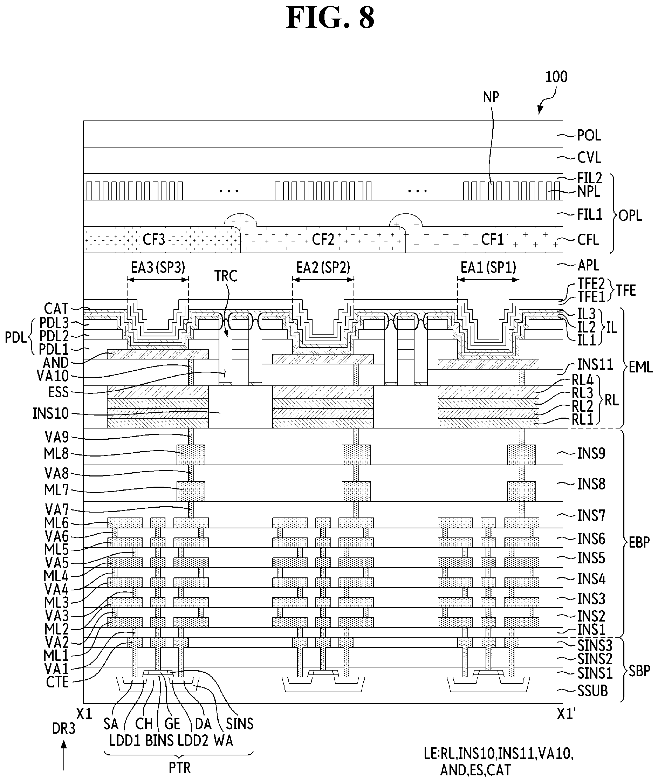

FIG. 8 is a cross-sectional view illustrating another example of a display panel taken along the line X1-X1' of FIG. 5.

Referring to FIG. 8, the base layer BAS may be omitted. In this case, the nano pattern layer NPL may be directly disposed on the first filling layer FIL1.

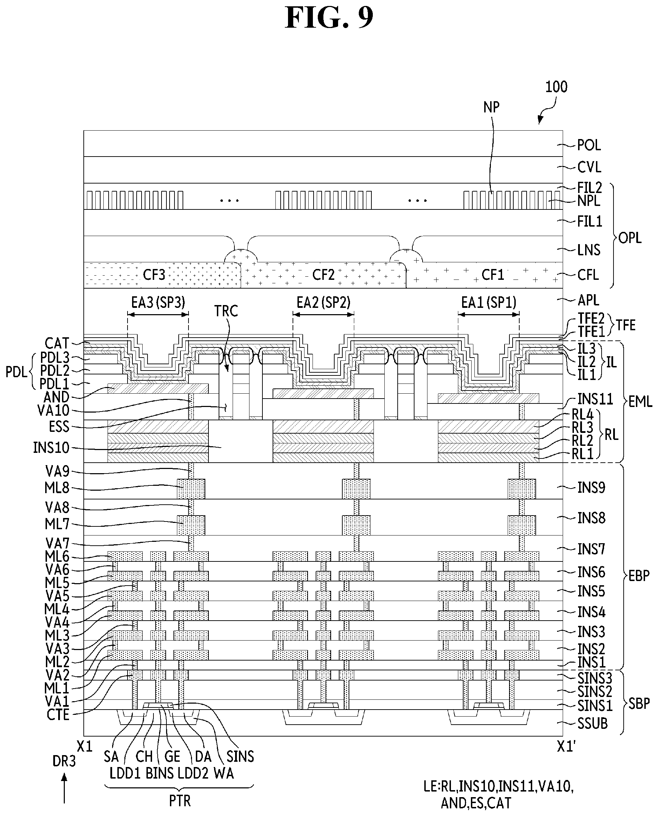

FIG. 9 is a cross-sectional view illustrating still another example of a display panel taken along the line X1-X1'of FIG. 5.

Referring to FIG. 9, the optical layer OPL may further include a plurality of lenses LNS. The plurality of lenses LNS may be disposed on the first color filter CF1, the second color filter CF2, and the third color filter CF3, respectively. Each of the plurality of lenses LNS may be a structure for increasing the proportion of light directed to the front of the display device 10. Each of the plurality of lenses LNS may have a cross-sectional shape that is convex in an upward direction. In one or more embodiments, the plurality of lenses LNS may be a micro lens array (MLA).

FIG. 10 is a schematic cross-sectional view illustrating a display element layer, a color filter layer, lenses, a nano pattern layer, and an optical module of a display device according to one or more embodiments. FIG. 11 is a schematic cross-sectional view illustrating a display panel and an optical module according to one or more embodiments.

Referring to FIGS. 10 and 11 in addition to FIGS. 7 - 9, the display device 10 may include a display panel 100 and an optical module 800 disposed on the display panel 100.

Since the display panel 100 is described with reference to FIG. 7 and the like, the description of the display panel 100 will be omitted.

As illustrated in FIG. 11, the optical module 800 may include a first optical module 810, a second optical module 820, a third optical module 830, and a fourth optical module 840. The first optical module 810 may be disposed on the display panel 100, the second optical module 820 may be disposed on the first optical module 810, the third optical module 830 may be disposed on the second optical module 820, and the fourth optical module 840 may be disposed on the third optical module 830.

In one or more embodiments, the first optical module 810 may be directly disposed on the display panel 100. For example, the first optical module 810 may be directly attached on the display panel 100. The second optical module 820 may be spaced (e.g., spaced apart) from the first optical module 810, the third optical module 830 may be spaced (e.g., spaced apart) from the second optical module 820, and the fourth optical module 840 may be spaced (e.g., spaced apart) from the third optical module 830. An air gap filled with air may be placed between the second optical module 820 and the first optical module 810, between the third optical module 830 and the second optical module 820, and between the fourth optical module 840 and the third optical module 830.

The first optical module 810 may be the same component as the polarizing plate POL of the display panel 100 described with reference to FIG. 7 and/or the like. The display device 10 may include one from among the polarizing plate POL of the display panel 100 or the first optical module 810 of the optical module 800.

Each of the second to fourth optical modules 820 to 840 may include a lens. Each lens included in the second to fourth optical modules 820 to 840 may enlarge an image formed by light emitted from the display panel 100. Various lens such as a convex lens, a concave lens, a meniscus lens, and a fresnel lens may be used as the lens included in the second to fourth optical modules 820 to 840, and the shape and size of each lens included in the second to fourth optical modules 820 to 840 are not limited thereto.

Each lens included in the second to fourth optical modules 820 to 840 may include at least one concave surface or convex surface. The highest point (e.g., 820a and 840a in the drawing), which is the most convex part, may be located on the convex surface, and the lowest point (e.g., 830a in the drawing), which is the most concave part, may be located on the concave surface. In one or more embodiments, the highest points 820a and 840a and the lowest point 830a of each lens included in the second to fourth optical modules 820 to 840 may be disposed on one straight line.

The display panel 100 may include a first pixel PX1, a second pixel PX2, and a third pixel PX3. The first pixel PX1 is a pixel PX that is located at the center from among the plurality of pixels PX included in the display panel 100. The third pixel PX3 is a pixel PX located at the edge from among the plurality of pixels PX included in the display panel 100. The second pixel PX2 is a pixel PX located between the first pixel PX1 and the third pixel PX3 from among the plurality of pixels PX included in the display panel 100.

Here, the center means a point (e.g., 100a in the drawing) located on the one straight line placed in parallel to the above-described highest points 820a and 840a and the lowest point 830a. The highest points 820a and 840a and the lowest point 830a of each lens included in the second to fourth optical modules 820 to 840 and the point 100a may be disposed on the one straight line (e.g., the highest points 820a and 840a and the lowest point 830a may be co-linear).

Each of the first to third pixels PX1, PX2, and PX3 may include a first sub-pixel SP1, a second sub-pixel SP2, and a third sub-pixel SP3. Each of the first sub-pixel SP1, the second sub-pixel SP2, and the third sub-pixel SP3 of each of the first to third pixels PX1, PX2, and PX3 may include a first emission area EA1, a second emission area EA2, and a third emission area EA3, respectively. For example, the first sub-pixel SP1 of each of the first to third pixels PX1, PX2, and PX3 may include the first emission area EA1, the second sub-pixel SP2 of each of the first to third pixels PX1, PX2, and PX3 may include the second emission area EA2, and the third sub-pixel SP3 of each of the first to third pixels PX1, PX2, and PX3 may include the third emission area EA3.

In the display device 10 of the present embodiment, the plurality of lenses LNS and the plurality of color filters CF1, CF2, and CF3 may be disposed on one straight line with the plurality of emission areas EA1, EA2, and EA3, respectively. For example, as illustrated in the drawing, the central portion of the plurality of lenses LNS and the central portion of the plurality of color filters CF1, CF2, and CF3 may be disposed in parallel to the plurality of emission areas EA1, EA2, and EA3 on a first straight line L0 extending in the third direction DR3.

For example, in the case of the display device 10 according to the comparative embodiment, the second emission area EA2 of the second sub-pixel SP2 of the first pixel PX1, the second color filter CF2 overlapping the second emission area EA2, and the lens LNS overlapping the second emission area EA2 may be disposed on one straight line. In the case of the display device 10 according to the comparative embodiment, in order to improve the average luminance amount based on a distribution of chief ray angle (CRA), the third emission area EA3 of the third sub-pixel SP3 of the third pixel PX3 located at the edge of the display panel 100, the third color filter CF3 overlapping the third emission area EA3, and the lens LNS overlapping the third emission area EA3 may be shifted in one direction (e.g., the horizontal direction of the drawing) and be disposed.

On the other hand, the display device 10 according to the present embodiment may achieve the average luminance amount based on the distribution of chief ray angle (CRA) without the shift arrangement of the plurality of color filters CF1, CF2, and CF3 and the plurality of lenses LNS through the nano pattern layer NPL

Specifically, in order to increase field of view (FOV), control stray light, and prevent distortion of an image, the light may be incident substantially parallel to the normal line (e.g., the third direction DR3 in the drawing) when the light emitted from the first pixel PX1 located at the center of the display panel 100 is incident on the optical module 800. However, when the light emitted from the third pixel PX3 located at the edge of the display panel 100 is incident on the optical module 800, the light may be incident while substantially having a suitable first angle (e.g., a predetermined first angle) θ1 with respect to the normal line. The first angle θ1 may be a chief ray angle (CRA) of light emitted from the third pixel PX3 which is the pixel at the edge. In one or more embodiments, the first angle θ1 may be approximately 25 to 35 degrees.

In the case of the display device 10 according to the comparative embodiment, as the color filters CF1, CF2, and CF3, and the lens LNS are shifted relative to the emission areas EA1, EA2, and EA3, the path of light may be adjusted according to the distribution of chief ray angle (CRA). However, in the case of the display device 10 according to the present embodiment, the path of light may be adjusted according to the distribution of chief ray angle (CRA) through the diffraction of light by a plurality of nano patterns NP of the nano pattern layer NPL. Accordingly, the field of view (FOV) increases, and cost savings and improved process efficiency can be achieved through process simplification by not applying shift arrangements.

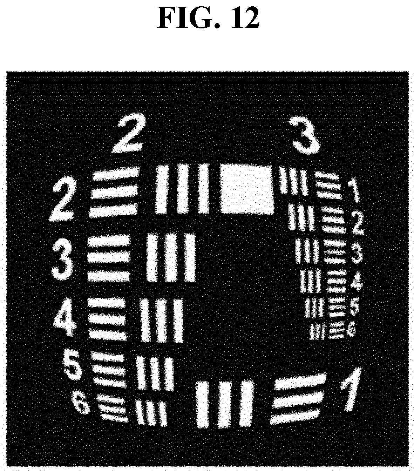

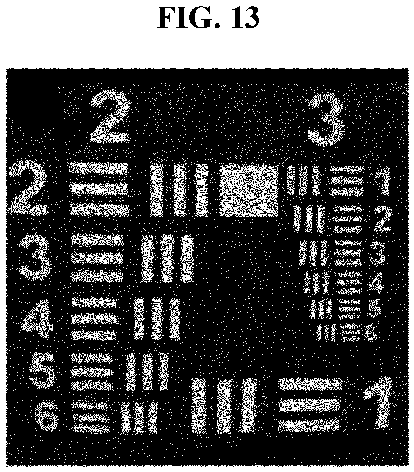

FIG. 12 is a view illustrating an example of an image displayed by a display device according to a comparative embodiment. FIG. 13 is a view illustrating an example of an image displayed by a display device according to one or more embodiments.

Referring to FIGS. 12 and 13 in addition to FIG. 10, the display device 10 according to a comparative embodiment may not include an optical module 800. Accordingly, as illustrated in FIG. 12, a distortion of image edge according to chief ray angle (CRA) may occur. However, the display device 10 according to the present embodiment may include an optical module 800. Accordingly, as illustrated in FIG. 13, a distortion of image edge according to chief ray angle (CRA) may not occur.

In addition, the display device 10 according to the present embodiment may improve luminance amount based on a distribution of chief ray angle (CRA) through the nano pattern layer NPL. For example, as the nano pattern layer NPL diffracts light based on the distribution of chief ray angle (CRA), the luminance amount of light that is reduced while passing through the optical module 800 may be minimized.

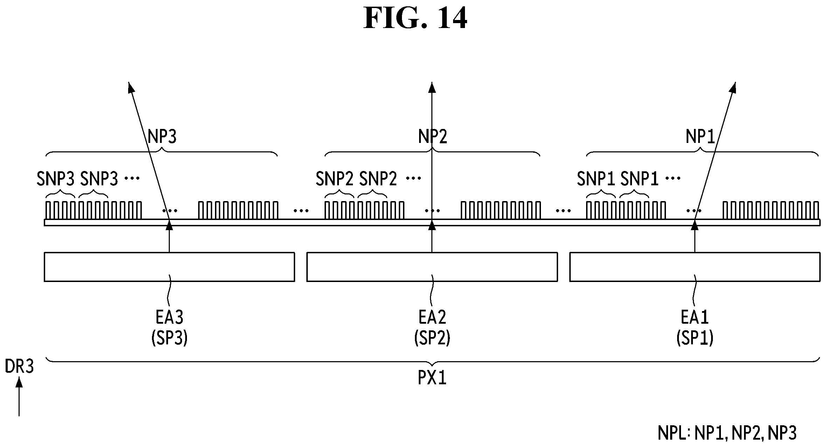

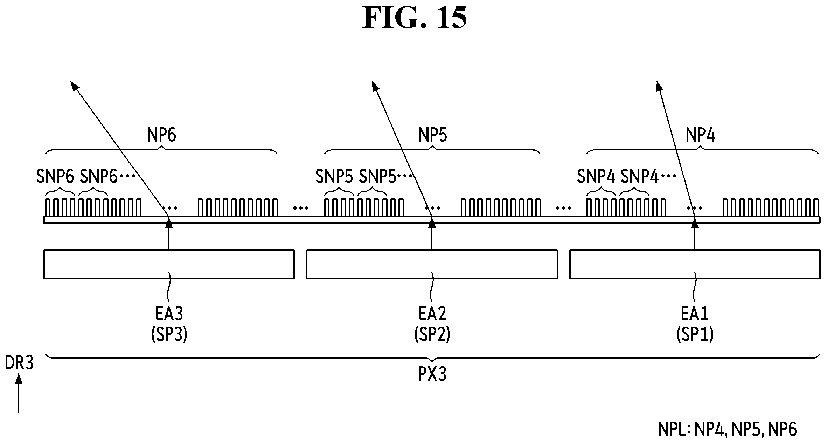

FIG. 14 is a cross-sectional view illustrating nano patterns overlapping the first pixel illustrated in FIG. 10. FIG. 15 is a cross-sectional view illustrating nano patterns overlapping the third pixel illustrated in FIG. 10.

Referring to FIGS. 14 and 15 in addition to FIGS. 7 and 10, the display panel 100 may include a first pixel PX1 located at the center of the display panel 100 and a third pixel PX3 located at the edge of the display panel 100.

The first pixel PX1 may include a first sub-pixel SP1, a second sub-pixel SP2, and a third sub-pixel SP3. The first sub-pixel SP1 of the first pixel PX1 may include a first emission area EA1, the second sub-pixel SP2 of the first pixel PX1 may include a second emission area EA2, and the third sub-pixel SP3 of the first pixel PX1 may include a third emission area EA3.

The third pixel PX3 may include a first sub-pixel SP1, a second sub-pixel SP2, and a third sub-pixel SP3. The first sub-pixel SP1 of the third pixel PX3 may include a first emission area EA1, the second sub-pixel SP2 of the third pixel PX3 may include a second emission area EA2, and the third sub-pixel SP3 of the third pixel PX3 may include a third emission area EA3.

The nano pattern layer NPL may include a plurality of nano patterns NP. For example, the nano pattern layer NPL may include a first nano pattern NP1 overlapping the first emission area EA1 of the first sub-pixel SP1 of the first pixel PX1, a second nano pattern NP2 overlapping the second emission area EA2 of the second sub-pixel SP2 of the first pixel PX1, a third nano pattern NP3 overlapping the third emission area EA3 of the third sub-pixel SP3 of the first pixel PX1, a fourth nano pattern NP4 overlapping the first emission area EA1 of the first sub-pixel SP1 of the third pixel PX3, a fifth nano pattern NP5 overlapping the second emission area EA2 of the second sub-pixel SP2 of the third pixel PX3, and a sixth nano pattern NP6 overlapping the third emission area EA3 of the third sub-pixel SP3 of the third pixel PX3.

The second nano pattern NP2 may be located at the center of the display panel 100. The first nano pattern NP1 and the third nano pattern NP3 may be located on one side and the other side of the second nano pattern NP2. The sixth nano pattern NP6 may be located at the edge of the display panel 100. For example, the sixth nano pattern NP6 may be located at the left edge of the display panel 100. The fifth nano pattern NP5 may be located on one side of the sixth nano pattern NP6, and the fifth nano pattern NP5 may be located at the edge of the display panel 100 next to the sixth nano pattern NP6. The fourth nano pattern NP4 may be located on one side of the fifth nano pattern NP5, and the fourth nano pattern NP4 may be located at the edge of the display panel 100 next to the fifth nano pattern NP5. The fourth nano pattern NP4 may be located closer to the center of the display panel 100 than the fifth nano pattern NP5, and the fifth nano pattern NP5 may be located closer to the center of the display panel 100 than the sixth nano pattern NP6.

The first nano pattern NP1 may include at least one first sub-nano pattern SNP1. The second nano pattern NP2 may include at least one second sub-nano pattern SNP2. The third nano pattern NP3 may include at least one third sub-nano pattern SNP3. The fourth nano pattern NP4 may include at least one fourth sub-nano pattern SNP4. The fifth nano pattern NP5 may include at least one fifth sub-nano pattern SNP5. The sixth nano pattern NP6 may include at least one sixth sub-nano pattern SNP6.

Each of the first to sixth sub-nano patterns SNP1, SNP2, SNP3, SNP4, SNP5, and SNP6 may be a unit pattern of the respective first to sixth nano patterns NP1, NP2, NP3, NP4, NP5, and NP6. For example, in the case where the first to sixth nano patterns NP1, NP2, NP3, NP4, NP5, and NP6 respectively include a plurality of first to sixth sub-nano patterns SNP1, SNP2, SNP3, SNP4, SNP5, and SNP6, the first to sixth nano patterns NP1, NP2, NP3, NP4, NP5, and NP6 may each include a plurality of first to sixth sub-nano patterns SNP1, SNP2, SNP3, SNP4, SNP5, and SNP6 that are arranged repeatedly.

The emission areas EA1, EA2, and EA3 may overlap at least one sub-nano pattern. For example, as illustrated in FIGS. 14 and 15, the first emission area EA1 of the first sub-pixel SP1 of the first pixel PX1 may overlap a plurality of first sub-nano patterns SNP1, the second emission area EA2 of the second sub-pixel SP2 of the first pixel PX1 may overlap a plurality of second sub-nano patterns SNP2, the third emission area EA3 of the third sub-pixel SP3 of the first pixel PX1 may overlap a plurality of third sub-nano patterns SNP3, the first emission area EA1 of the first sub-pixel SP1 of the third pixel PX3 may overlap a plurality of fourth sub-nano patterns SNP4, the second emission area EA2 of the second sub-pixel SP2 of the third pixel PX3 may overlap a plurality of fifth sub-nano patterns SNP5, and the third emission area EA3 of the third sub-pixel SP3 of the third pixel PX3 may overlap a plurality of sixth sub-nano patterns SNP6.

The first to sixth sub-nano patterns SNP1, SNP2, SNP3, SNP4, SNP5, and SNP6 may each include a plurality of nano structures STR (see FIG. 16). For example, as illustrated in the drawing, the first to sixth sub-nano patterns SNP1, SNP2, SNP3, SNP4, SNP5, and SNP6 may each include four nano structures STR (see FIG. 16). However, the number of nano structures STR (see FIG. 16) included in each of the first to sixth sub-nano patterns SNP1, SNP2, SNP3, SNP4, SNP5, and SNP6 is not limited thereto.

In the display device 10 according to the present embodiment, the second nano pattern NP2 may maintain the path of light emitted from the second emission area EA2 of the second sub-pixel SP2 of the first pixel PX1. For example, the second nano pattern NP2 may allow the light emitted from the second emission area EA2 of the second sub-pixel SP2 of the first pixel PX1 to pass straight without diffracting.

The first nano pattern NP1 may change the path of light emitted from the first emission area EA1 of the first sub-pixel SP1 of the first pixel PX1. The third nano pattern NP3 may change the path of light emitted from the third emission area EA3 of the third sub-pixel SP3 of the first pixel PX1. The fourth nano pattern NP4 may change the path of light emitted from the first emission area EA1 of the first sub-pixel SP1 of the third pixel PX3. The fifth nano pattern NP5 may change the path of light emitted from the second emission area EA2 of the second sub-pixel SP2 of the third pixel PX3. The sixth nano pattern NP6 may change the path of light emitted from the third emission area EA3 of the third sub-pixel SP3 of the third pixel PX3.

In one or more embodiments, the progression angle of the light passing through the nano pattern NP with respect to the front direction (e.g., the third direction DR3 in the drawing) may increase from the nano pattern NP located at the center of the display panel 100 toward the nano pattern NP located at the edge of the display panel 100. For example, the progression angle of the light passing through the second nano pattern NP2 with respect to the front direction may be zero, and the angle of the light passing through the first nano pattern NP1, the third nano pattern NP3, the fourth nano pattern NP4, the fifth nano pattern NP5, and the sixth nano pattern NP6 with respect to the front direction may be greater than zero.

The progression angle of the light passing through the first nano pattern NP1 with respect to the front direction may be substantially the same as the progression angle of the light passing through the third nano pattern NP3 with respect to the front direction. The progression angle of the light passing through the fourth nano pattern NP4 with respect to the front direction may be greater than the progression angle of the light passing through each of the first nano pattern NP1 and the third nano pattern NP3 with respect to the front direction. The progression angle of the light passing through the fifth nano pattern NP5 with respect to the front direction may be greater than the progression angle of the light passing through the fourth nano pattern NP4 with respect to the front direction. The progression angle of the light passing through the sixth nano pattern NP6 with respect to the front direction may be greater than the progression angle of the light passing through the fifth nano pattern NP5 with respect to the front direction.

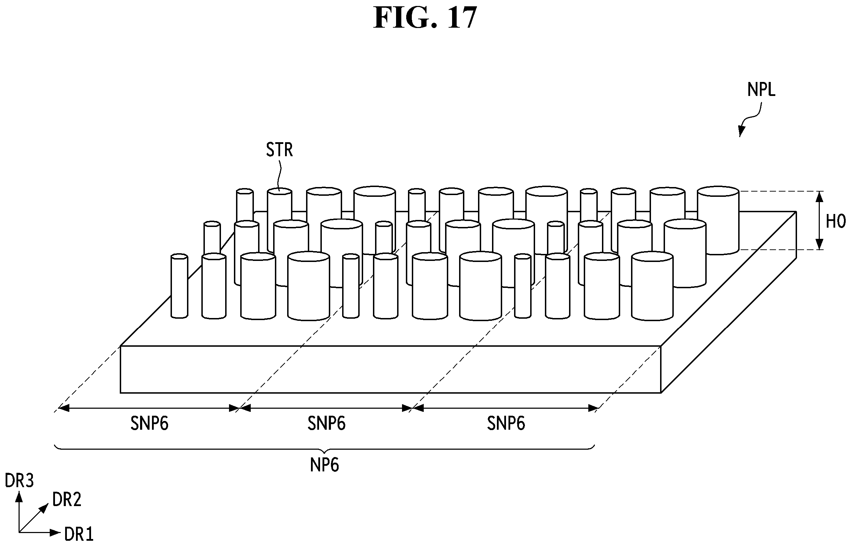

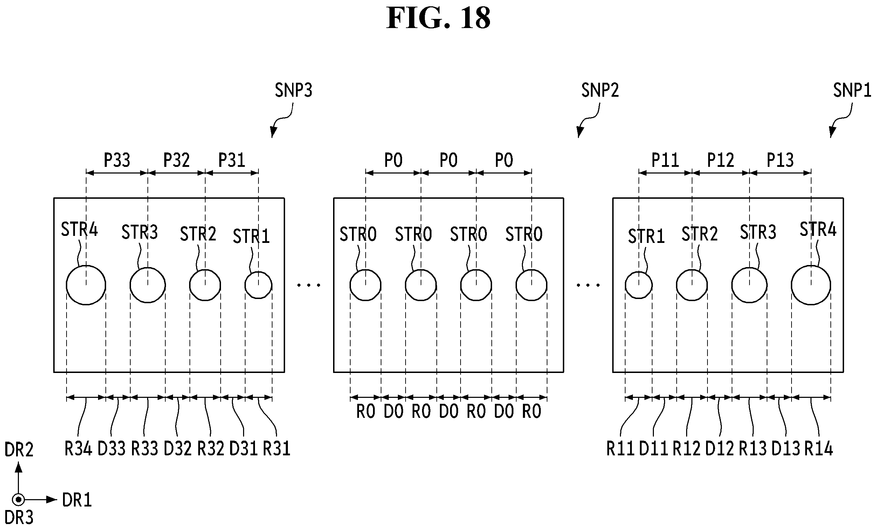

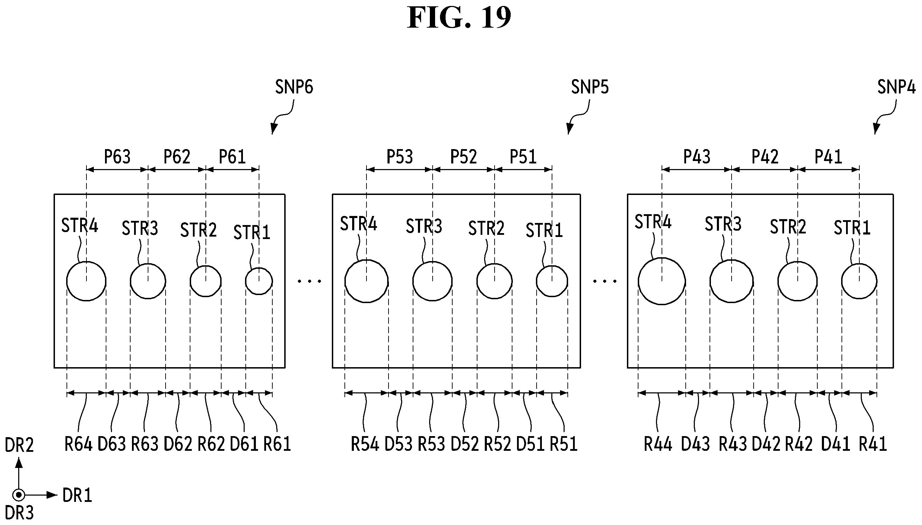

FIG. 16 is a perspective view illustrating a second nano pattern from among a nano pattern layer according to one or more embodiments. FIG. 17 is a perspective view illustrating a sixth nano pattern from among a nano pattern layer according to one or more embodiments. FIG. 18 is a plan view illustrating first to third nano patterns from among a nano pattern layer according to one or more embodiments. FIG. 19 is a plan view illustrating fourth to sixth nano patterns from among a nano pattern layer according to one or more embodiments.

Referring to FIGS. 16 - 19 in addition to FIGS. 7, 10, 14, and 15, the nano pattern NP may include a plurality of nano structures STR. In one or more embodiments, the height of the nano structures STR may be approximately, 200 nm to 400 nm, preferably, 300 nm to 350 nm. In one or more embodiments, the diameter of the nano structures STR may be approximately 100 nm to 200 nm. The plurality of nano structures STR may have a shape of a pillar (e.g., a nano-rod shape), but the present disclosure is not limited thereto.

In one or more embodiments, the nano structure STR may include amorphous silicon. In one or more other embodiments, the nano structure STR may include a single-crystal silicon and/or a polycrystalline silicon.

In one or more embodiments, the nano structure STR may include metal. For example, the nano structure STR may include at least one of gold (Au), silver (Ag), aluminium (Al), copper (Cu), nickel (Ni), titanium (Ti), tungsten (W), molybdenum (Mo), chromium (Cr), neodymium (Nd), and/or an alloy thereof.

The nano structures STR included in the second sub-nano pattern SNP2 of the second nano pattern NP2 located at the center of the display panel 100 may have the same size, gap distance, and the distance between each center.

For example, as illustrated in FIGS. 16 and 18, one second sub-nano pattern SNP2 may include four nano structures STR0. A height H0 of each of the nano structures STR0 included in the second sub-nano pattern SNP2 may be the same. A diameter R0 (or width) of each of the nano structures STR0 included in the second sub-nano pattern SNP2 may be the same. A distance D0 between the nano structures STR0 included in the second sub-nano pattern SNP2 may be the same. A distance P0 between each center of the nano structures STR0 included in the second sub-nano pattern SNP2 may be the same.

At least one of the size, the gap distance, and the distance between each center of the nano structures STR included in the sixth sub-nano pattern SNP6 of the sixth nano pattern NP6 located at the edge of the display panel 100 may be different.

For example, as illustrated in FIGS. 17 and 19, one sixth sub-nano pattern SNP6 may include four nano structures STR1, STR2, STR3, and STR4. The sixth sub-nano pattern SNP6 may include a first nano structure STR1, a second nano structure STR2, a third nano structure STR3, and a fourth nano structure STR4. The first nano structure STR1 of the sixth sub-nano pattern SNP6 may be disposed on one side of the second nano structure STR2 of the sixth sub-nano pattern SNP6 in the first direction DR1, the second nano structure STR2 of the sixth sub-nano pattern SNP6 may be disposed on one side of the third nano structure STR3 of the sixth sub-nano pattern SNP6 in the first direction DR1, and the third nano structure STR3 of the sixth sub-nano pattern SNP6 may be disposed on one side of the fourth nano structure STR4 of the sixth sub-nano pattern SNP6 in the first direction DR1. The first nano structure STR1, the second nano structure STR2, the third nano structure STR3, and the fourth nano structure STR4 of the sixth sub-nano pattern SNP6 may be arranged away from the center of the display panel 100 in that sequential order.

A height H0 of each of the first nano structure STR1, the second nano structure STR2, the third nano structure STR3, and the fourth nano structure STR4 of the sixth sub-nano pattern SNP6 may be the same.

The diameter of each of the first nano structure STR1, the second nano structure STR2, the third nano structure STR3, and the fourth nano structure STR4 of the sixth sub-nano pattern SNP6 may be different. For example, a diameter R61 of the first nano structure STR1 of the sixth sub-nano pattern SNP6 may be smaller than a diameter R62 of the second nano structure STR2 of the sixth sub-nano pattern SNP6, the diameter R62 of the second nano structure STR2 of the sixth sub-nano pattern SNP6 may be smaller than a diameter R63 of the third nano structure STR3 of the sixth sub-nano pattern SNP6, and the diameter R63 of the third nano structure STR3 of the sixth sub-nano pattern SNP6 may be smaller than a diameter R64 of the fourth nano structure STR4 of the sixth sub-nano pattern SNP6.

In one or more embodiments, the diameter R61 (or width) of the first nano structure STR1 of the sixth sub-nano pattern SNP6 may be approximately 94 nm to 134 nm, the diameter R62 (or width) of the second nano structure STR2 of the sixth sub-nano pattern SNP6 may be approximately 104 nm to 144 nm, the diameter R63 (or width) of the third nano structure STR3 of the sixth sub-nano pattern SNP6 may be approximately 114 nm to 154 nm, and the diameter R64 (or width) of the fourth nano structure STR4 of the sixth sub-nano pattern SNP6 may be approximately 150 nm to 190 nm.

In one or more embodiments, the distances between the first nano structure STR1, the second nano structure STR2, the third nano structure STR3, and the fourth nano structure STR4 of the sixth sub-nano pattern SNP6 may be the same. For example, a distance D61 between the first nano structure STR1 of the sixth sub-nano pattern SNP6 and the second nano structure STR2 of the sixth sub-nano pattern SNP6, a distance D62 between the second nano structure STR2 of the sixth sub-nano pattern SNP6 and the third nano structure STR3 of the sixth sub-nano pattern SNP6, and a distance D63 between the third nano structure STR3 of the sixth sub-nano pattern SNP6 and the fourth nano structure STR4 of the sixth sub-nano pattern SNP6 may be the same.

In one or more embodiments, the distances between the center of each of the first nano structure STR1, the second nano structure STR2, the third nano structure STR3, and the fourth nano structure STR4 of the sixth sub-nano pattern SNP6 may be different. For example, a distance P61 between each center of the first nano structure STR1 of the sixth sub-nano pattern SNP6 and the second nano structure STR2 of the sixth sub-nano pattern SNP6 may be smaller than a distance P62 between each center of the second nano structure STR2 of the sixth sub-nano pattern SNP6 and the third nano structure STR3 of the sixth sub-nano pattern SNP6, and the distance P62 between each center of the second nano structure STR2 of the sixth sub-nano pattern SNP6 and the third nano structure STR3 of the sixth sub-nano pattern SNP6 may be smaller than a distance P63 between each center of the third nano structure STR3 of the sixth sub-nano pattern SNP6 and the fourth nano structure STR4 of the sixth sub-nano pattern SNP6.

As described above, because the second nano pattern NP2 located at the center of the display panel 100 has the same size and gap distance of the nano structure STR of the second sub-nano pattern SNP2, the path of light passing through the nano pattern NP may be maintained in the straight direction (e.g., the third direction DR3). However, because at least one of the size, the gap distance, and the distance between each center of the nano structure STR of the sixth sub-nano pattern SNP6 is different in the sixth nano pattern NP6 located at the edge of the display panel 100, the path of light passing through the nano pattern NP may be changed by a light diffraction phenomenon. For example, the progression direction of light may be changed from the first nano structure STR1 having a small size to the fourth nano structure STR4 having a large size in the sixth nano pattern NP6.

In one or more embodiments, the nano pattern NP located between the center and the edge of the display panel 100 may adjust the size, the gap distance, and the distance between each center of the nano structure STR to adjust the degree of diffraction of light.

Specifically, the first nano pattern NP1 disposed on one side of the second nano pattern NP2 in the first direction may include a first sub-nano pattern SNP1. At least one of the size, the gap distance, and the distance between each center of the nano structures STR included in the first sub-nano pattern SNP1 may be different.

For example, as illustrated in FIG. 18, one first sub-nano pattern SNP1 may include four nano structures STR1, STR2, STR3, and STR4. The first sub-nano pattern SNP1 may include a first nano structure STR1, a second nano structure STR2, a third nano structure STR3, and a fourth nano structure STR4. The fourth nano structure STR4 of the first sub-nano pattern SNP1 may be disposed on one side of the third nano structure STR3 of the first sub-nano pattern SNP1 in the first direction DR1, the third nano structure STR3 of the first sub-nano pattern SNP1 may be disposed on one side of the second nano structure STR2 of the first sub-nano pattern SNP1 in the first direction DR1, and the second nano structure STR2 of the first sub-nano pattern SNP1 may be disposed on one side of the first nano structure STR1 of the first sub-nano pattern SNP1 in the first direction DR1. The first nano structure STR1, the second nano structure STR2, the third nano structure STR3, and the fourth nano structure STR4 of the first sub-nano pattern SNP1 may be disposed arranged away from the center of the display panel 100 in that sequential order.

The diameter of each of the first nano structure STR1, the second nano structure STR2, the third nano structure STR3, and the fourth nano structure STR4 of the first sub-nano pattern SNP1 may be different. For example, a diameter R11 of the first nano structure STR1 of the first sub-nano pattern SNP1 may be smaller than a diameter R12 of the second nano structure STR2 of the first sub-nano pattern SNP1, the diameter R12 of the second nano structure STR2 of the first sub-nano pattern SNP1 may be smaller than a diameter R13 of the third nano structure STR3 of the first sub-nano pattern SNP1, and the diameter R13 of the third nano structure STR3 of the first sub-nano pattern SNP1 may be smaller than a diameter R14 of the fourth nano structure STR4 of the first sub-nano pattern SNP1.

In one or more embodiments, the distances between the first nano structure STR1, the second nano structure STR2, the third nano structure STR3, and the fourth nano structure STR4 of the first sub-nano pattern SNP1 may be the same. For example, a distance D11 between the first nano structure STR1 of the first sub-nano pattern SNP1 and the second nano structure STR2 of the first sub-nano pattern SNP1, a distance D12 between the second nano structure STR2 of the first sub-nano pattern SNP1 and the third nano structure STR3 of the first sub-nano pattern SNP1, and a distance D13 between the third nano structure STR3 of the first sub-nano pattern SNP1 and the fourth nano structure STR4 of the first sub-nano pattern SNP1 may be the same.

In one or more embodiments, the distances between the center of each of the first nano structure STR1, the second nano structure STR2, the third nano structure STR3, and the fourth nano structure STR4 of the first sub-nano pattern SNP1 may be different. For example, a distance P11 between each center of the first nano structure STR1 of the first sub-nano pattern SNP1 and the second nano structure STR2 of the first sub-nano pattern SNP1 may be smaller than a distance P12 between each center of the second nano structure STR2 of the first sub-nano pattern SNP1 and the third nano structure STR3 of the first sub-nano pattern SNP1, and the distance P12 between each center of the second nano structure STR2 of the first sub-nano pattern SNP1 and the third nano structure STR3 of the first sub-nano pattern SNP1 may be smaller than a distance P13 between each center of the third nano structure STR3 of the first sub-nano pattern SNP1 and the fourth nano structure STR4 of the first sub-nano pattern SNP1.

In one or more embodiments, the heights of the first nano structure STR1, the second nano structure STR2, the third nano structure STR3, and the fourth nano structure STR4 may be the same.

The third nano pattern NP3 disposed on the other side of the second nano pattern NP2 in the first direction DR1 may include a third sub-nano pattern SNP3. At least one of the size, the gap distance, and the distance between each center of the nano structures STR included in the third sub-nano pattern SNP3 may be different.

For example, as illustrated in FIG. 18, one third sub-nano pattern SNP3 may include four nano structures STR1, STR2, STR3, and STR4. The third sub-nano pattern SNP3 may include a first nano structure STR1, a second nano structure STR2, a third nano structure STR3, and a fourth nano structure STR4. The first nano structure STR1 of the third sub-nano pattern SNP3 may be disposed on one side of the second nano structure STR2 of the third sub-nano pattern SNP3 in the first direction DR1, the second nano structure STR2 of the third sub-nano pattern SNP3 may be disposed on one side of the third nano structure STR3 of the third sub-nano pattern SNP3 in the first direction DR1, and the third nano structure STR3 of the third sub-nano pattern SNP3 may be disposed on one side of the fourth nano structure STR4 of the third sub-nano pattern SNP3 in the first direction DR1. The first nano structure STR1, the second nano structure STR2, the third nano structure STR3, and the fourth nano structure STR4 of the third sub-nano pattern SNP3 may be disposed arranged away from the center of the display panel 100 in that sequential order.

The diameter of each of the first nano structure STR1, the second nano structure STR2, the third nano structure STR3, and the fourth nano structure STR4 of the third sub-nano pattern SNP3 may be different. For example, a diameter R31 of the first nano structure STR1 of the third sub-nano pattern SNP3 may be smaller than a diameter R32 of the second nano structure STR2 of the third sub-nano pattern SNP3, the diameter R32 of the second nano structure STR2 of the third sub-nano pattern SNP3 may be smaller than a diameter R33 of the third nano structure STR3 of the third sub-nano pattern SNP3, and the diameter R33 of the third nano structure STR3 of the third sub-nano pattern SNP3 may be smaller than a diameter R34 of the fourth nano structure STR4 of the third sub-nano pattern SNP3.

In one or more embodiments, the distances between the first nano structure STR1, the second nano structure STR2, the third nano structure STR3, and the fourth nano structure STR4 of the third sub-nano pattern SNP3 may be the same. For example, a distance D31 between the first nano structure STR1 of the third sub-nano pattern SNP3 and the second nano structure STR2 of the third sub-nano pattern SNP3, a distance D32 between the second nano structure STR2 of the third sub-nano pattern SNP3 and the third nano structure STR3 of the third sub-nano pattern SNP3, and a distance D33 between the third nano structure STR3 of the third sub-nano pattern SNP3 and the fourth nano structure STR4 of the third sub-nano pattern SNP3 may be the same.

In one or more embodiments, the distances between the center of each of the first nano structure STR1, the second nano structure STR2, the third nano structure STR3, and the fourth nano structure STR4 of the third sub-nano pattern SNP3 may be different. For example, a distance P31 between each center of the first nano structure STR1 of the third sub-nano pattern SNP3 and the second nano structure STR2 of the third sub-nano pattern SNP3 may be smaller than a distance P32 between each center of the second nano structure STR2 of the third sub-nano pattern SNP3 and the third nano structure STR3 of the third sub-nano pattern SNP3, and the distance P32 between each center of the second nano structure STR2 of the third sub-nano pattern SNP3 and the third nano structure STR3 of the third sub-nano pattern SNP3 may be smaller than a distance P33 between each center of the third nano structure STR3 of the third sub-nano pattern SNP3 and the fourth nano structure STR4 of the third sub-nano pattern SNP3.

In one or more embodiments, the heights of the first nano structure STR1, the second nano structure STR2, the third nano structure STR3, and the fourth nano structure STR4 of the third sub-nano pattern SNP3 may be the same.

In one or more embodiments, as illustrated in FIG. 18, the first sub-nano pattern SNP1 and the third sub-nano pattern SNP3 may be left and right symmetrical with respect to the second sub-nano pattern SNP2.

In one or more embodiments, the fifth nano pattern NP5 disposed on one side of the sixth nano pattern NP6 in the first direction DR1 may include a fifth sub-nano pattern SNP5. At least one of the size, the gap distance, and the distance between each center of the nano structures STR included in the fifth sub-nano pattern SNP5 may be different.

For example, as illustrated in FIG. 19, one fifth sub-nano pattern SNP5 may include four nano structures STR1, STR2, STR3, and STR4. The fifth sub-nano pattern SNP5 may include a first nano structure STR1, a second nano structure STR2, a third nano structure STR3, and a fourth nano structure STR4. The first nano structure STR1 of the fifth sub-nano pattern SNP5 may be disposed on one side of the second nano structure STR2 of the fifth sub-nano pattern SNP5 in the first direction DR1, the second nano structure STR2 of the fifth sub-nano pattern SNP5 may be disposed on one side of the third nano structure STR3 of the fifth sub-nano pattern SNP5 in the first direction DR1, and the third nano structure STR3 of the fifth sub-nano pattern SNP5 may be disposed on one side of the fourth nano structure STR4 of the fifth sub-nano pattern SNP5 in the first direction DR1. The first nano structure STR1, the second nano structure STR2, the third nano structure STR3, and the fourth nano structure STR4 of the fifth sub-nano pattern SNP5 may be disposed arranged away from the center of the display panel 100 in that sequential order.

The diameter of each of the first nano structure STR1, the second nano structure STR2, the third nano structure STR3, and the fourth nano structure STR4 of the fifth sub-nano pattern SNP5 may be different. For example, a diameter R51 of the first nano structure STR1 of the fifth sub-nano pattern SNP5 may be smaller than a diameter R52 of the second nano structure STR2 of the fifth sub-nano pattern SNP5, the diameter R52 of the second nano structure STR2 of the fifth sub-nano pattern SNP5 may be smaller than a diameter R53 of the third nano structure STR3 of the fifth sub-nano pattern SNP5, and the diameter R53 of the third nano structure STR3 of the fifth sub-nano pattern SNP5 may be smaller than a diameter R54 of the fourth nano structure STR4 of the fifth sub-nano pattern SNP5.

In one or more embodiments, the distances between the first nano structure STR1, the second nano structure STR2, the third nano structure STR3, and the fourth nano structure STR4 of the fifth sub-nano pattern SNP5 may be the same. For example, a distance D51 between the first nano structure STR1 of the fifth sub-nano pattern SNP5 and the second nano structure STR2 of the fifth sub-nano pattern SNP5, a distance D52 between the second nano structure STR2 of the fifth sub-nano pattern SNP5 and the third nano structure STR3 of the fifth sub-nano pattern SNP5, and a distance D53 between the third nano structure STR3 of the fifth sub-nano pattern SNP5 and the fourth nano structure STR4 of the fifth sub-nano pattern SNP5 may be the same.

In one or more embodiments, the distances between the center of each of the first nano structure STR1, the second nano structure STR2, the third nano structure STR3, and the fourth nano structure STR4 of the fifth sub-nano pattern SNP5 may be different. For example, a distance P51 between each center of the first nano structure STR1 of the fifth sub-nano pattern SNP5 and the second nano structure STR2 of the fifth sub-nano pattern SNP5 may be smaller than a distance P52 between each center of the second nano structure STR2 of the fifth sub-nano pattern SNP5 and the third nano structure STR3 of the fifth sub-nano pattern SNP5, and the distance P52 between each center of the second nano structure STR2 of the fifth sub-nano pattern SNP5 and the third nano structure STR3 of the fifth sub-nano pattern SNP5 may be smaller than a distance P53 between each center of the third nano structure STR3 of the fifth sub-nano pattern SNP5 and the fourth nano structure STR4 of the fifth sub-nano pattern SNP5.

In one or more embodiments, the heights of the first nano structure STR1, the second nano structure STR2, the third nano structure STR3, and the fourth nano structure STR4 of the fifth sub-nano pattern SNP5 may be the same.

The fourth nano pattern NP4 disposed on one side of the fifth nano pattern NP5 in the first direction DR1 may include a fourth sub-nano pattern SNP4. At least one of the size, the gap distance, and the distance between each center of the nano structures STR included in the fourth sub-nano pattern SNP4 may be different.

For example, as illustrated in FIG. 19, one fourth sub-nano pattern SNP4 may include four nano structures STR1, STR2, STR3, and STR4. The fourth sub-nano pattern SNP4 may include a first nano structure STR1, a second nano structure STR2, a third nano structure STR3, and a fourth nano structure STR4. The first nano structure STR1 of the fourth sub-nano pattern SNP4 may be disposed on one side of the second nano structure STR2 of the fourth sub-nano pattern SNP4 in the first direction DR1, the second nano structure STR2 of the fourth sub-nano pattern SNP4 may be disposed on one side of the third nano structure STR3 of the fourth sub-nano pattern SNP4 in the first direction DR1, and the third nano structure STR3 of the fourth sub-nano pattern SNP4 may be disposed on one side of the fourth nano structure STR4 of the fourth sub-nano pattern SNP4 in the first direction DR1. The first nano structure STR1, the second nano structure STR2, the third nano structure STR3, and the fourth nano structure STR4 of the fourth sub-nano pattern SNP4 may be disposed arranged away from the center of the display panel 100 in that sequential order.

The diameter of each of the first nano structure STR1, the second nano structure STR2, the third nano structure STR3, and the fourth nano structure STR4 of the fourth sub-nano pattern SNP4 may be different. For example, a diameter R41 of the first nano structure STR1 of the fourth sub-nano pattern SNP4 may be smaller than a diameter R42 of the second nano structure STR2 of the fourth sub-nano pattern SNP4, the diameter R42 of the second nano structure STR2 of the fourth sub-nano pattern SNP4 may be smaller than a diameter R43 of the third nano structure STR3 of the fourth sub-nano pattern SNP4, and the diameter R43 of the third nano structure STR3 of the fourth sub-nano pattern SNP4 may be smaller than a diameter R44 of the fourth nano structure STR4 of the fourth sub-nano pattern SNP4.

In one or more embodiments, the distances between the first nano structure STR1, the second nano structure STR2, the third nano structure STR3, and the fourth nano structure STR4 of the fourth sub-nano pattern SNP4 may be the same. For example, a distance D41 between the first nano structure STR1 of the fourth sub-nano pattern SNP4 and the second nano structure STR2 of the fourth sub-nano pattern SNP4, a distance D42 between the second nano structure STR2 of the fourth sub-nano pattern SNP4 and the third nano structure STR3 of the fourth sub-nano pattern SNP4, and a distance D43 between the third nano structure STR3 of the fourth sub-nano pattern SNP4 and the fourth nano structure STR4 of the fourth sub-nano pattern SNP4 may be the same.

In one or more embodiments, the distances between the center of each of the first nano structure STR1, the second nano structure STR2, the third nano structure STR3, and the fourth nano structure STR4 of the fourth sub-nano pattern SNP4 may be different. For example, a distance P41 between each center of the first nano structure STR1 of the fourth sub-nano pattern SNP4 and the second nano structure STR2 of the fourth sub-nano pattern SNP4 may be smaller than a distance P42 between each center of the second nano structure STR2 of the fourth sub-nano pattern SNP4 and the third nano structure STR3 of the fourth sub-nano pattern SNP4, and the distance P42 between each center of the second nano structure STR2 of the fourth sub-nano pattern SNP4 and the third nano structure STR3 of the fourth sub-nano pattern SNP4 may be smaller than a distance P43 between each center of the third nano structure STR3 of the fourth sub-nano pattern SNP4 and the fourth nano structure STR4 of the fourth sub-nano pattern SNP4.

In one or more embodiments, the heights of the first nano structure STR1, the second nano structure STR2, the third nano structure STR3, and the fourth nano structure STR4 of the fourth sub-nano pattern SNP4 may be the same.

In one or more embodiments, the size of the nano structures STR located at the same location of the sub-nano pattern may increase from the edge toward the center of the display panel 100, the distance between the nano structures STR located at the same location may decrease from the edge toward the center of the display panel 100, and the distance between each center of nano structures STR located at the same location may be constant.

For example, as illustrated in FIG. 19, the diameter R41 of the first nano structure STR1 of the fourth sub-nano pattern SNP4 may be greater than the diameter R51 of the first nano structure STR1 of the fifth sub-nano pattern SNP5, and the diameter R51 of the first nano structure STR1 of the fifth sub-nano pattern SNP5 may be greater than the diameter R61 of the first nano structure STR1 of the sixth sub-nano pattern SNP6. The diameter R42 of the second nano structure STR2 of the fourth sub-nano pattern SNP4 may be greater than the diameter R52 of the second nano structure STR2 of the fifth sub-nano pattern SNP5, and the diameter R52 of the second nano structure STR2 of the fifth sub-nano pattern SNP5 may be greater than the diameter R62 of the second nano structure STR2 of the sixth sub-nano pattern SNP6. The diameter R43 of the third nano structure STR3 of the fourth sub-nano pattern SNP4 may be greater than the diameter R53 of the third nano structure STR3 of the fifth sub-nano pattern SNP5, and the diameter R53 of the third nano structure STR3 of the fifth sub-nano pattern SNP5 may be greater than the diameter R63 of the third nano structure STR3 of the sixth sub-nano pattern SNP6. The diameter R44 of the fourth nano structure STR4 of the fourth sub-nano pattern SNP4 may be greater than a diameter R54 of the fourth nano structure STR4 of the fifth sub-nano pattern SNP5, and the diameter R54 of the fourth nano structure STR4 of the fifth sub-nano pattern SNP5 may be greater than the diameter R64 of the fourth nano structure STR4 of the sixth sub-nano pattern SNP6.

The distance D41 between the first nano structure STR1 of the fourth sub-nano pattern SNP4 and the second nano structure STR2 of the fourth sub-nano pattern SNP4, the distance D42 between the second nano structure STR2 of the fourth sub-nano pattern SNP4 and the third nano structure STR3 of the fourth sub-nano pattern SNP4, and the distance D43 between the third nano structure STR3 of the fourth sub-nano pattern SNP4 and the fourth nano structure STR4 of the fourth sub-nano pattern SNP4 may be smaller than the distance D51 between the first nano structure STR1 of the fifth sub-nano pattern SNP5 and the second nano structure STR2 of the fifth sub-nano pattern SNP5, the distance D52 between the second nano structure STR2 of the fifth sub-nano pattern SNP5 and the third nano structure STR3 of the fifth sub-nano pattern SNP5, and the distance D53 between the third nano structure STR3 of the fifth sub-nano pattern SNP5 and the fourth nano structure STR4 of the fifth sub-nano pattern SNP5, respectively. The distance D51 between the first nano structure STR1 of the fifth sub-nano pattern SNP5 and the second nano structure STR2 of the fifth sub-nano pattern SNP5, the distance D52 between the second nano structure STR2 of the fifth sub-nano pattern SNP5 and the third nano structure STR3 of the fifth sub-nano pattern SNP5, and the distance D53 between the third nano structure STR3 of the fifth sub-nano pattern SNP5 and the fourth nano structure STR4 of the fifth sub-nano pattern SNP5 may be smaller than the distance D61 between the first nano structure STR1 of the sixth sub-nano pattern SNP6 and the second nano structure STR2 of the sixth sub-nano pattern SNP6, the distance D62 between the second nano structure STR2 of the sixth sub-nano pattern SNP6 and the third nano structure STR3 of the sixth sub-nano pattern SNP6, and the distance D63 between the third nano structure STR3 of the sixth sub-nano pattern SNP6 and the fourth nano structure STR4 of the sixth sub-nano pattern SNP6, respectively.

The distance P41 between each center of the first nano structure STR1 of the fourth sub-nano pattern SNP4 and the second nano structure STR2 of the fourth sub-nano pattern SNP4, the distance P51 between each center of the first nano structure STR1 of the fifth sub-nano pattern SNP5 and the second nano structure STR2 of the fifth sub-nano pattern SNP5, and the distance P61 between each center of the first nano structure STR1 of the sixth sub-nano pattern SNP6 and the second nano structure STR2 of the sixth sub-nano pattern SNP6 may be the same. The distance P42 between each center of the second nano structure STR2 of the fourth sub-nano pattern SNP4 and the third nano structure STR3 of the fourth sub-nano pattern SNP4, the distance P52 between each center of the second nano structure STR2 of the fifth sub-nano pattern SNP5 and the third nano structure STR3 of the fifth sub-nano pattern SNP5, and the distance P62 between each center of the second nano structure STR2 of the sixth sub-nano pattern SNP6 and the third nano structure STR3 of the sixth sub-nano pattern SNP6 may be the same. The distance P43 between each center of the third nano structure STR3 of the fourth sub-nano pattern SNP4 and the fourth nano structure STR4 of the fourth sub-nano pattern SNP4, the distance P53 between each center of the third nano structure STR3 of the fifth sub-nano pattern SNP5 and the fourth nano structure STR4 of the fifth sub-nano pattern SNP5, and the distance P63 between each center of the third nano structure STR3 of the sixth sub-nano pattern SNP6 and the fourth nano structure STR4 of the sixth sub-nano pattern SNP6 may be the same.

Because the fourth nano pattern NP4 is disposed closer to the center of the display panel 100 than the fifth nano pattern NP5 and the fifth nano pattern NP5 is disposed closer to the center of the display panel 100 than the sixth nano pattern NP6, the fourth nano pattern NP4 may include a larger nano structure than the fifth nano pattern NP5 and the fifth nano pattern NP5 may include a larger nano structure than the sixth nano pattern NP6, and thus, the fourth nano pattern NP4 may diffract less light than the fifth nano pattern NP5 and the fifth nano pattern NP5 may diffract less light than the sixth nano pattern NP6. Like described above, the nano pattern NP located between the center and the edge of the display panel 100 may adjust the size, the gap distance, and the distance between each center of the nano structures STR to adjust the degree of diffraction of light.

Hereinafter, other embodiments of the display device according to one or more embodiments will be described. In the following embodiments, description of the same components as those of the above-described embodiment, which are denoted by like reference numerals, will be omitted or simplified, and differences will be mainly described.

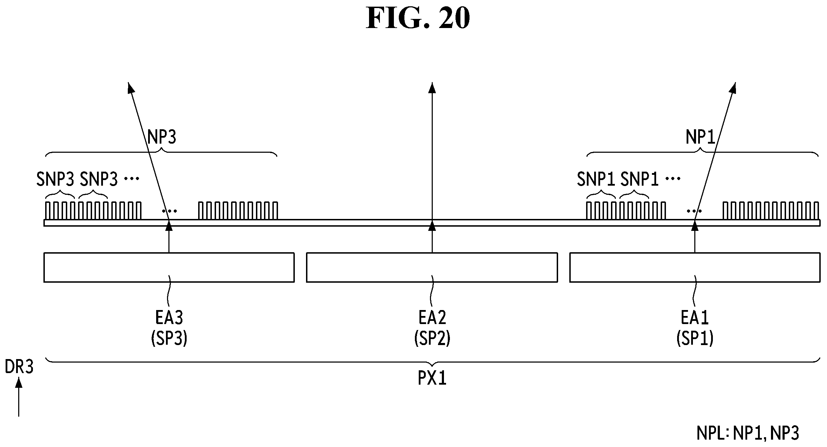

FIG. 20 is a cross-sectional view illustrating nano patterns overlapping a first pixel of a display device according to one or more embodiments.

Referring to FIG. 20, a display device 10 according to the present embodiment is different from the display device 10 according to one embodiment described with reference to FIG. 14 and the like in that it does not include the second nano pattern NP2.

More specifically, the nano pattern layer NPL may include a first nano pattern NP1 overlapping the first emission area EA1 of the first sub-pixel SP1 of the first pixel PX1 and a third nano pattern NP3 overlapping the third emission area EA3 of the third sub-pixel SP3 of the first pixel PX1. The nano pattern layer NPL may not include a nano pattern NP in an area overlapping the second emission area EA2 of the second sub-pixel SP2 of the first pixel PX1.

Accordingly, the path of light emitted from the second emission area EA2 of the second sub-pixel SP2 of the first pixel PX1 may be maintained. In addition, as the nano pattern NP is not disposed in the area overlapping the second emission area EA2 of the second sub-pixel SP2 of the first pixel PX1, light emission efficiency of the display device 10 may be improved.

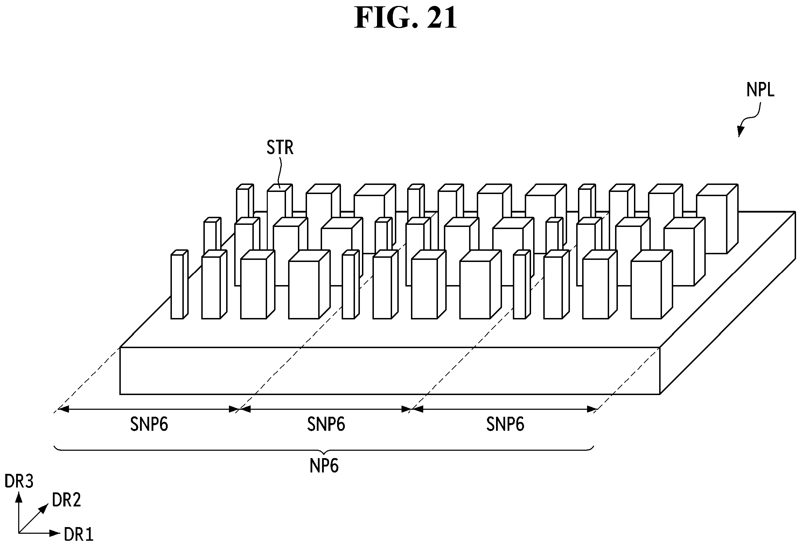

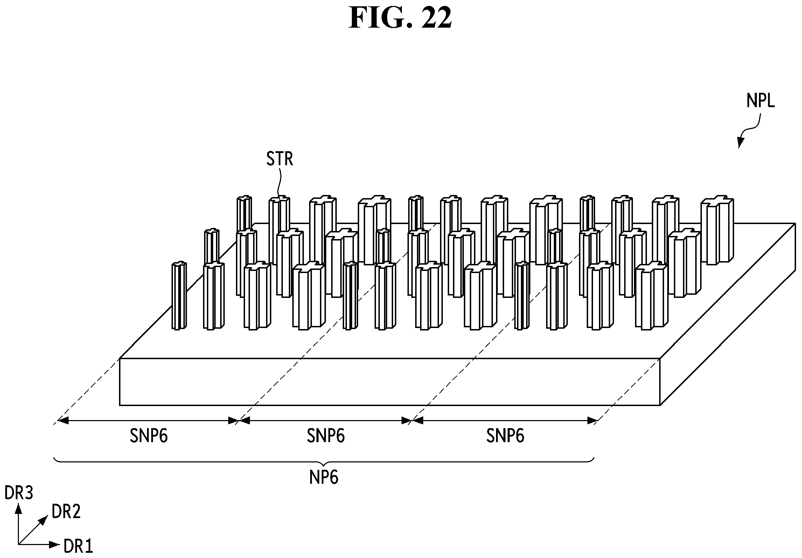

FIG. 21 is a perspective view illustrating a nano pattern layer according to still another embodiment. FIG. 22 is a perspective view illustrating a nano pattern layer according to still another embodiment.

Referring to FIGS. 21 and 22, a display device 10 according to the present embodiment is different from the display device 10 according to the embodiment described with reference to FIG. 17 and the like in that the shape of the nano structure is different.

In one or more embodiments, the nano structure STR may have a square pillar shape (e.g., a nano-pin shape) as illustrated in FIG. 21. In one or more other embodiments, the nano structure STR may have a cross pillar shape (e.g., a nano-polygon shape) as illustrated in FIG. 22.

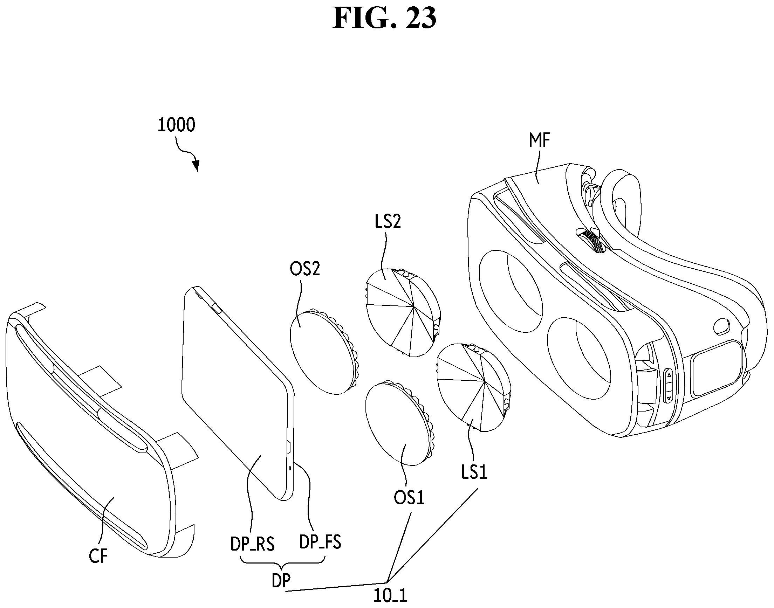

FIG. 23 is an exploded perspective view illustrating a head mounted display device according to one or more embodiments.

Referring to FIG. 23, a head mounted display 1000 is formed in the form of glasses or a head mount to provide an image to a user using a display device 10_1.

The head mounted display 1000 may include a see-through type that provides augmented reality based on actual external objects and a see-closed type that provides virtual reality to the user on a screen independent from the external objects.

The head mounted display 1000 may include a main frame MF mounted on the user's body, the display device 10_1 mounted on the main frame MF to display an image, and a cover frame CF that covers the display device 10_1.

The display device 10_1 may be formed integrally with the head mounted display 1000 that may be carried by the user and easily attached to or detached from a face or a head, and may be formed to be assembled to the head mounted display 1000. The display device 10_1 may be substantially the same as the display device 10 described in conjunction with FIG. 1 and the like.

The display device 10_1 may include a display panel DP that displays an image, first and second lens frames OS1 and OS2 that refract an image display light, and first and second multi-channel lenses LS1 and LS2 that form an optical path so that the image display light of the display panel DP is visible to the user.

The main frame MF may be worn on the user's face and head. The main frame MF may be formed in a shape corresponding to the user's head and facial structure.

The main frame MF may be integrally formed with display device 10_1, that is, the display panel DP, the first and second lens frames OS1 and OS2, and the first and second multi-channel lenses LS1 and LS2. Alternatively, the display panel DP, the first and second lens frames OS1 and OS2, and the first and second multi-channel lenses LS1 and LS2 may be assembled and mounted to the main frame MF. To this end, the main frame MF may have a space or a structure for accommodating the display panel DP, the first and second lens frames OS1 and OS2, and the first and second multi-channel lenses LS1 and LS2. The main frame MF may further include a structure such as a strap or a band to facilitate the mounting, and a controller, an image processing unit, and a lens accommodating unit may be further included in the main frame MF.

The display panel DP may be divided into a front surface DP_FS where an image is displayed, and a rear surface DP_RS located on the opposite side of the front surface DP_FS. Image display light may be emitted from the front surface DP_FS of the display panel DP. As will be described later, the first and second lens frames OS1 and OS2 may be disposed on the front surface DP_FS of the display panel DP, and the first and second multi-channel lenses LS1 and LS2 may be disposed on the front surfaces of the first and second lens frames OS1 and OS2. In one or more embodiments, at least one infrared camera may be disposed on at least one of the front surface DP_FS or the rear surface DP_RS of the display panel DP. The display panel DP may be substantially the same as the display panel 100 described in conjunction with FIG. 1 and/or the like.

The display panel DP may be built in the main frame MF in a state where the first and second lens frames OS1 and OS2 and the first and second multi-channel lenses LS1 and LS2 are mounted and fixed, or may be detachably assembled to the main frame MF. The display panel DP may be opaque, transparent, or translucent depending on the design of the display device 10_1, for example, the usage type of the display device 10_1.

Each of the first and second lens frames OS1 and OS2 may have an area corresponding to the image display surface of the display panel DP, and may be formed in a shape corresponding to that of the image display surface. Further, the first and second lens frames OS1 and OS2 may be formed to have an area and a shape corresponding to those of the rear surfaces of the first and second multi-channel lenses LS1 and LS2, respectively. The rear surfaces of the first and second lens frames OS1 and OS2 may be attached to the image display surface of the display panel DP, and the first and second multi-channel lenses LS1 and LS2 may be attached to the front surfaces of the first and second lens frames OS1 and OS2, respectively. The first and second lens frames OS1 and OS2 refract the image display light emitted from the image display surface of the display panel DP at a preset angle and provide it to the first and second multi-channel lenses LS1 and LS2 disposed on the front surfaces thereof, respectively.

Specifically, the first and second lens frames OS1 and OS2 may refract the image display light, which is emitted from the image display surface of the display panel DP toward the front side, toward an outer side (or toward an outer peripheral side) compared to the front side and provide it to the first and second multi-channel lenses LS1 and LS2 disposed on the front surfaces thereof, respectively. In particular, the first and second lens frames OS1 and OS2 may refract the image display light incident on the rear surfaces thereof toward the outer side (or toward the outer peripheral side) and provide it to the rear surfaces of the first and second multi-channel lenses LS1 and LS2, respectively.

The first and second multi-channel lenses LS1 and LS2 may form a path for light emitted through the first and second lens frames OS1 and OS2, so that the image display light is visible to the user's eyes on the front side.

The first and second multi-channel lenses LS1 and LS2 may provide a plurality of channels (or paths) through which the image display light emitted from the display panel DP passes. The plurality of channels may provide the image display light emitted from the display panel DP to the user through different paths. The image display light emitted through the first and second lens frames OS1 and OS2 may be incident on the respective channels, and the image magnified through the respective channels may be focused on the user's eyes.

The first and second multi-channel lenses LS1 and LS2 may be respectively arranged on the front surfaces of the first and second lens frames OS1 and OS2 to correspond to the positions of the user's left eye and right eye. The first and second multi-channel lenses LS1 and LS2 may be accommodated in the main frame MF.

The first and second multi-channel lenses LS1 and LS2 may refract and/or reflect the image display light emitted through the first and second lens frames OS1 and OS2 at least once to form a path to the user's eyes. At least one infrared light source may be further disposed at the main frame MF, or on one side of each of the first and second multi-channel lenses LS1 and LS2 facing the user's eyes.

The cover frame CF may be disposed on the rear surface DP_RS of the display panel DP to cover the display panel DP and may protect the display panel DP. The cover frame CF may be attached to the main frame MF while covering the display panel DP.

In one or more embodiments, the display device 10_1 may further include a controller for controlling the overall operation of the display device 10_1 including the display panel DP. The controller may control the image display operation of the display panel DP and audio devices. Specifically, the controller performs image processing (e.g., image mapping) according to the magnification ratio and the image display path corresponding to the first and second lens frames OS1 and OS2 and the first and second multi-channel lenses LS1 and LS2, and controls the mapped image to be displayed on the display panel DP. The controller may be implemented as a dedicated processor including an embedded processor and/or a general-purpose processor including a central processing unit or an application processor, but is not limited thereto.

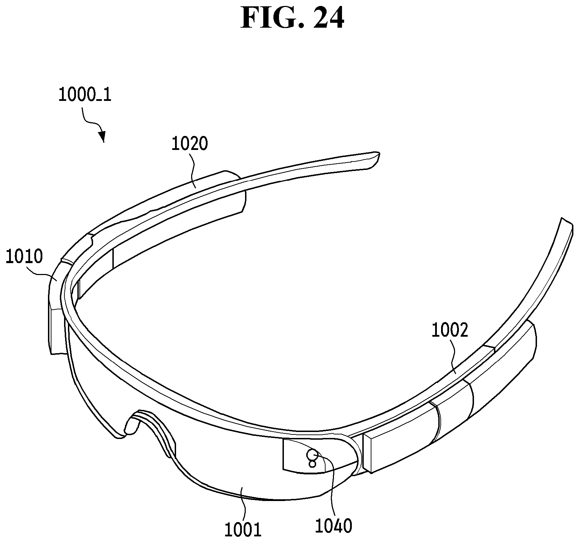

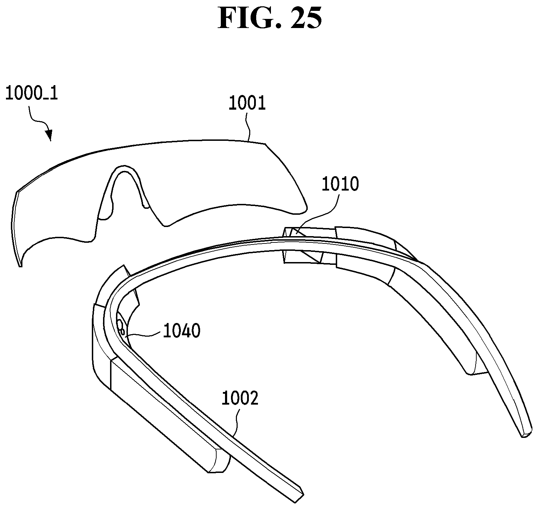

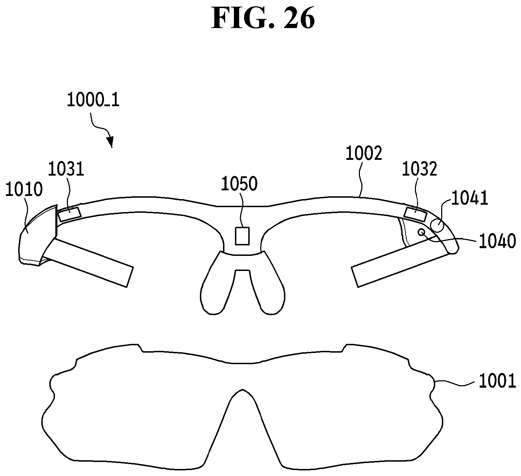

FIG. 24 is a perspective view illustrating an augmented reality content providing device according to one or more embodiments. FIG. 25 is a rear exploded perspective view of the augmented reality content providing device of FIG. 24. FIG. 26 is a front exploded perspective view of the augmented reality content providing device of FIG. 24.

Referring to FIGS. 24 - 26, an augmented reality content providing device 1000_1 may include a support frame 1002 supporting at least one transparent lens 1001, at least one image display module 1010, a surrounding environment detector 1040, and a control module 1020.

The support frame 1002 may be formed in the form of glasses including a spectacle frame supporting the edge of at least one transparent lens 1001 and spectacle frame legs. The shape of the support frame 1002 is not limited to a glasses type, and may be formed in a goggle type including the transparent lens 1001, or a head mount type.

The transparent lens 1001 may include left and right parts formed integrally, or first and second transparent lenses formed separately. The transparent lens 1001, which includes the integrated left and right parts or the separated first and second transparent lenses, may be made of glass or plastic that is transparent or translucent. Accordingly, the user can view the image of reality through the transparent lens 1001 that includes the integrated right and left parts or the separated first and second transparent lenses. Here, the transparent lens 1001, that is, the integrated lens or the first and second transparent lenses, may have a refractive power in consideration of the user's eyesight.

The transparent lens 1001 may further include at least one reflective member that reflects the augmented reality content image provided from the at least one image display module 1010 toward the transparent lens 1001 or the user's eyes, and optical members that adjust a focus and a size. One or more reflective members may be built in the transparent lens 1001 to be integrated with the transparent lens 1001, and may be formed as a plurality of refractive lenses or a plurality of prisms with a suitable curvature (e.g., a predetermined curvature).

The at least one image display module 1010 may include a micro LED (micro-LED) display device, a nano LED (nano-LED) display device, an organic light emitting diode (OLED) display device, an inorganic light emitting diode (inorganic EL) display device, a quantum dot light emitting diode (QD-LED) display device, a cathode ray tube (CRT) display device, a liquid crystal display (LCD) device, and/or the like. The image display module 1010 may substantially include the display device 10 described with reference to FIG. 1 and/or the like.

The surrounding environment detector 1040 is assembled or integrally formed with the support frame 1002, and detects the distance (or depth) to an object on the front side of the support frame 1002, the illuminance, the moving direction of the support frame 1002, the moving distance, the tilt, and/or the like. To this end, the surrounding environment detector 1040 includes a depth sensor 1041 such as an infrared sensor or a LiDAR sensor, and an image sensor 1050 such as a camera. Further, the surrounding environment detector 1040 may further include at least one motion sensor from among an illumination sensor, a human body detection sensor, a gyro sensor, a tilt sensor, and/or an acceleration sensor. Further, the surrounding environment detector 1040 may further include first and second biometric sensors 1031 and 1032 for detecting movement information of the user's eyes or pupils.

The surrounding environment detector 1040 may transmit sensing signals generated by the depth sensor 1041 and at least one motion sensor to the control module 1020 in real time. Further, the image sensor 1050 may transmit image data in units of at least one frame generated in real time to the control module 1020. The first and second biometric sensors 1031 and 1032 of the surrounding environment detector 1040 may transmit the detected pupil detection signals to the control module 1020.

The control module 1020 may be assembled to at least one side of the support frame 1002 together with the at least one image display module 1010 or may be formed integrally with the support frame 1002. The control module 1020 supplies augmented reality content data to the at least one image display module 1010 so that the at least one image display module 1010 displays an augmented reality content, e.g., an augmented reality content image. At the same time, the control module 1020 may receive sensing signals, image data, and pupil detection signals from the surrounding environment detector 1040 in real time.

In concluding the detailed description, those skilled in the art will appreciate that many variations and modifications can be made to the embodiments without substantially departing from the principles and scope of the present disclosure. Therefore, the embodiments of the present disclosure are used in a generic and descriptive sense only and not for purposes of limitation.

## Claims

1. A display device comprising:
a semiconductor substrate;
a plurality of light emitting elements on the semiconductor substrate; and
a plurality of patterns on the plurality of light emitting elements and overlapping the plurality of light emitting elements, wherein:
the plurality of light emitting elements comprises a first light emitting element at a center of the display device and a second light emitting element on one side of the first light emitting element;
the plurality of patterns comprises a first pattern overlapping the first light emitting element and a second pattern overlapping the second light emitting element;
the first pattern comprises a first structure and a second structure;
the second pattern comprises a third structure and a fourth structure;
a width of the first structure and a width of the second structure are the same; and
a width of the third structure and a width of the fourth structure are different.

2. The display device of claim 1,
wherein the third structure is closer to the center than the fourth structure is, and
wherein the width of the third structure is smaller than the width of the fourth structure.

3. The display device of claim 1 or claim 2,
wherein the second pattern further comprises a fifth structure and a sixth structure,
wherein the third structure, the fourth structure, the fifth structure, and the sixth structure are arranged away from the center in that sequential order, and
wherein the widths the third structure, the fourth structure, the fifth structure, and the sixth structure increase in sequential order.

4. The display device of claim 3,
wherein the width of the third structure is 94 nm to 134 nm,
the width of the fourth structure is 104 nm to 144 nm,
the width of the fifth structure is 114 nm to 154 nm, and
the width of the sixth structure is 150 nm to 190 nm.

5. The display device of claim 4,
wherein the second pattern is configured to tilt light proceeding in a thickness direction of the semiconductor substrate through the second pattern by 25 to 35 degrees.

6. The display device of any one of claims 1 to 5,
wherein the plurality of light emitting elements comprises a third light emitting element between the first light emitting element and the second light emitting element,
wherein the plurality of patterns comprises a third pattern overlapping the third light emitting element,
wherein the third pattern comprises a seventh structure and an eighth structure, and
wherein a width of the seventh structure and a width of the eighth structure are different.

7. The display device of claim 6,
wherein the seventh structure is closer to the center than the eighth structure is, and
the width of the seventh structure is smaller than the width of the eighth structure.

8. The display device of claim 6 or claim 7,
wherein the width of the third structure is smaller than the width of the seventh structure, and
the width of the fourth structure is smaller than the eighth structure, optionally wherein:
a distance between the third structure and the fourth structure is greater than the distance between the seventh structure and the eighth structure.

9. The display device of any one of claims 1 to 8,
wherein the plurality of light emitting elements comprises a fourth light emitting element on an other side of the first light emitting element,
wherein the plurality of patterns comprises a fourth pattern overlapping the fourth light emitting element,
wherein the fourth pattern comprises a ninth structure and a tenth structure, and
wherein a width of the ninth structure is the same as the width of the third structure, and a width of the tenth structure is the same as the width of the fourth structure, optionally wherein:
the second pattern and the fourth pattern are symmetrical to each other in left and right directions with respect to the first pattern.

10. The display device of any one of claims 1 to 9,
wherein the first to fourth structures comprise silicon or a metal.

11. A display device comprising:
a semiconductor substrate;
a plurality of light emitting elements on the semiconductor substrate; and
a pattern layer comprising a plurality of patterns overlapping the plurality of light emitting elements and located on the plurality of light emitting elements, wherein:
the plurality of light emitting elements comprises a first light emitting element at a center of the display device and a second light emitting element on one side of the first light emitting element,
the pattern layer does not comprise the pattern in the overlapping area with the first light emitting element and comprises a first pattern overlapping the second light emitting element,
the first pattern comprises a first structure and a second structure, and
a width of the first structure and a width of the second structure are different.

12. The display device of claim 11, wherein:
(i) the first structure is closer to the center than the second structure is, and
the width of the first structure is smaller than the width of the second structure; and/or
(ii) the first pattern further comprises a third structure and a fourth structure,
wherein the first structure, the second structure, the third structure, and the fourth structure are arranged away from the center in that sequential order, and
wherein the widths of the first structure, the second structure, the third structure, and the fourth structure increase in sequential order.

13. The display device of claim 11 or claim 12,
wherein the plurality of light emitting elements comprises a third light emitting element between the first light emitting element and the second light emitting element,
wherein the plurality of patterns comprises a second pattern overlapping the third light emitting element,
wherein the second pattern comprises a fifth structure and a sixth structure, and
wherein a width of the fifth structure and a width of the sixth structure are different.

14. The display device of any one of claims 11 to 13, wherein:
(i) the plurality of light emitting elements comprises a fourth light emitting element on an other side of the first light emitting element,
wherein the plurality of patterns comprises a third pattern overlapping the fourth light emitting element,
wherein the third pattern comprises a seventh structure and an eighth structure, and
wherein a width of the seventh structure is the same as the width of the first structure and a width of the eighth structure is the same as the width of the second structure; and/or
(ii) each of the plurality of light emitting elements and the plurality of patterns are on one straight line.

15. An electronic device comprising:
a display device; and
a display device driver configured to drive the display device, the display device comprising:
a semiconductor substrate;
a plurality of light emitting elements on the semiconductor substrate; and
a plurality of patterns on the plurality of light emitting elements and overlapping the plurality of light emitting elements, wherein:
the plurality of light emitting elements comprises a first light emitting element at a center of the display device and a second light emitting element on one side of the first light emitting element;
the plurality of patterns comprises a first pattern overlapping the first light emitting element and a second pattern overlapping the second light emitting element;
the first pattern comprises a first structure and a second structure;
the second pattern comprises a third structure and a fourth structure; and
a width of the first structure and a width of the second structure are the same, optionally wherein the electronic device comprises a mobile phone, a smartphone, a tablet personal computer, a mobile communication terminal, an electronic organizer, an electronic book, a portable multimedia player (PMP), a navigation system, an ultra-mobile PC (UMPC), televisions, laptops, monitors, billboards, a head mounted display (HMD), and an internet of things (IOT) terminal.
